Europäisches Patentamt

European Patent Office

Office européen des brevets

(19)

(11) **EP 0 701 174 A1**

(12) **EUROPEAN PATENT APPLICATION**

(43) Date of publication:
13.03.1996 Bulletin 1996/11

(51) Int. Cl.$^6$: **G03F 9/00**

(21) Application number: 95302844.6

(22) Date of filing: 27.04.1995

(84) Designated Contracting States:
**DE FR GB IT**

(30) Priority: 25.08.1994 JP 200480/94

(71) Applicant: **HITACHI, LTD.**
**Chiyoda-ku, Tokyo 100 (JP)**

(72) Inventors:
• **Komoriya, Susumu**
**Tokorozawa-shi, Saitama (JP)**
• **Machida, Takahiro**
**Kodaira-shi, Tokyo (JP)**

• **Kuniyoshi, Shinji**
**Sugunami-ku, Tokyo (JP)**
• **Iriki, Nobuyuki**
**Kodaira-shi, Tokyo (JP)**
• **Maejima, Hisashi**
**Higashiyamato-shi, Tokyo (JP)**
• **Kobayashi, Masamichi**
**Kodaira-shi, Tokyo (JP)**

(74) Representative: **Calderbank, Thomas Roger et al**
**MEWBURN ELLIS**
**York House**
**23 Kingsway**
**London WC2B 6HP (GB)**

(54) **Alignment mark and exposure process using the same**

(57) In order to provide a target pattern capable of producing position detection signals having high contrast and symmetry, a target pattern (1) to be detected by a position detecting optical system having an inspection light wavelength $\lambda$, a numerical aperture NA and a partial coherence $\sigma$ is composed of dot portions or line portions (1a) having a ridge width ($< 0.5\lambda (1 + \sigma)$/NA) and repeated step portions (1b) arranged around the dot or line portions (1a) and having a pitch P ($< \lambda (1 + \sigma)$/NA) and a ridge width W2 ($< 0.5 \lambda (1 + \sigma)$/NA). On the other hand, a target pattern (2) is composed of dot portions or line portions (2a) having a recess width W1 ($< 0.5\lambda (1 + \sigma)$/NA) and repeated step portions (2b) arranged around the dot or line portions (2a) and having a pitch P ($< \lambda (1 + \sigma)$/NA) and a ridge width W2 ($< 0.5\lambda (1 + \sigma)$/NA).

FIG. 1(a)

W1>0.5 λ (1+σ)/NA
1b
1a
P< λ (1+σ)/NA
W2<0.5 λ (1+σ)/NA
D> λ/16

IMPROVED TARGET 1

SPECIFIC EXAMPLE
WAVELENGTH λ =0.633 μm
NA=0.52
W1>0.61 μm (w=4 μm)
P<1.22 μm (P=1 μm)
W2<0.61 μm (W2=0.5 μm)
D>0.04 μm (D=0.16 μm)
σ≃0.4~0.7

FIG. 1(b)

W1>0.5 λ (1+σ)/NA
2b
2a
P< λ (1+σ)/NA
W2<0.5 λ(1+σ)/NA
D> λ/16

IMPROVED TARGET 2

SPECIFIC EXAMPLE
WAVELENGTH λ =0.633 μm
NA=0.52
W1>0.61 μm (w=4 μm)
P<1.22 μm (P=1 μm)
W2<0.61 μm (W2=0.5 μm)
D>0.04 μm (D=0.16 μm)
σ≃0.4~0.7

FIG. 1(c)

W>0.5 λ/NA
D> λ/16

CONVENTIONAL TARGET

SPECIFIC EXAMPLE
WAVELENGTH λ =0.633 μm
NA=0.52
W>0.61 μm (w=4 μm)
D>0.04 μm (D=0.16 μm)

## Description

The present invention relates to a signal processing technique, a technique for adjusting a position detecting optical system, a target pattern and an exposure technique and, more particularly, to a technique which is effective if applied to a process for manufacturing a semiconductor device as required to have a high precision alignment.

As disclosed in Japanese Patent Laid-Open No. 147151/1992, for example, the process for manufacturing a semiconductor device uses a projecting exposure apparatus for transferring a circuit pattern by projecting an exposure light having passed through an original of a reticle or the like upon a resist on a semiconductor wafer.

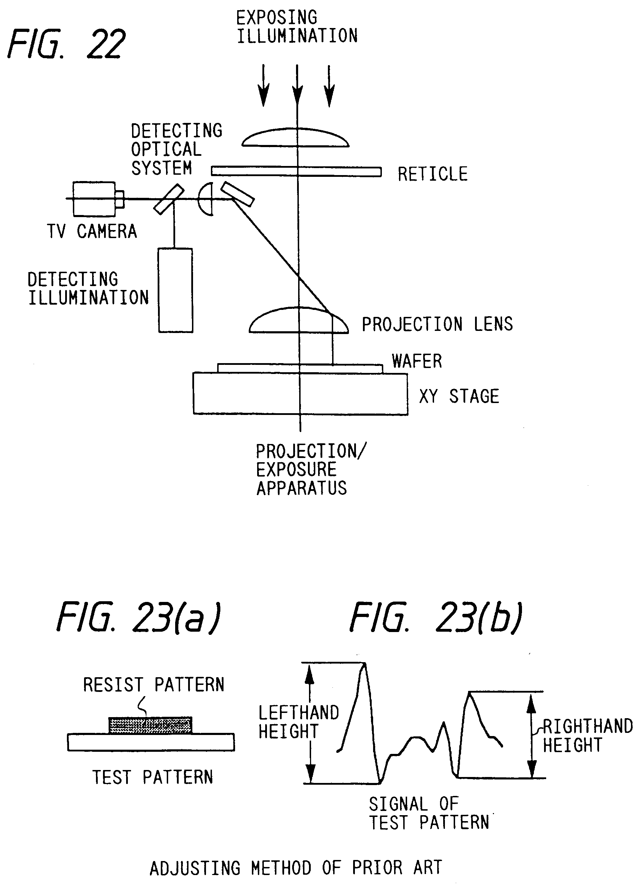

The projecting exposure apparatus for alignment by a bright field type detecting optical system is constructed, as shown in Fig. 22, to include a projection lens for projecting a pattern, an XY stage and a bright field detecting optical system for recognizing the position of a pattern. For this alignment, the pattern on the wafer is detected as graphic signals by the detecting optical system, and these graphic signals are stored in a memory and are processed to recognize the position of the pattern highly precisely.

In order to achieve a high alignment precision, an accurate adjustment is required for eliminating errors such as the optical aberrations of the detecting optical system or the misalignment of the detecting illumination optical axis.

The adjustment method of the bright field type detecting optical system of the prior art is exemplified, as shown in Figs. 23(a) and 23(b), by a method in which a resist pattern or the like is detected so that the adjustment may be decided from the difference between the levels of the righthand and lefthand signals of the detected waveform. However, this method highly resorts to the sense and experience of the operator, thus raising a problem that the method is seriously depends upon the individual differences.

A graphic signal (G) is stored as a function $G = G(i)$ as a position (i).

As the signal processing of the prior art, there is generally used a symmetric processing method, as disclosed in Japanese Patent Laid-Open No. 236117/1986, for example. This symmetric processing method calculates an inconsistency $Z(j)$ of symmetry for an arbitrary detection reference point (j) to determined a position in which the inconsistency $Z(j)$ takes the minimum. The symmetry is calculated by the following equation:

$$Z(j) = \sum_{k=k1}^{k=k2} [G(j-k) - G(j+k)]^2 \qquad (2).$$

Here, k: a variable of integration range of the symmetric processing from k1 to k2, both of which are positive integers. Letter j designates a variable of the detection reference point. In the present method, a symmetric error is determined for the reference point so that a highly precise detection can be achieved if the graphic signal is symmetric. In case, however, the waveform is outside of the aforementioned integration range, the value of the inconsistency $Z(J)$ is so small that a number of minimal values appear, thus raising a problem of a misunderstanding. Moreover, it is difficult to compare and evaluate the absolute values of symmetry of the waveform.

In order to align the wafer highly precisely, on the other hand, it is necessary to insert a target pattern which can produce signals having excellent contrast and symmetry.

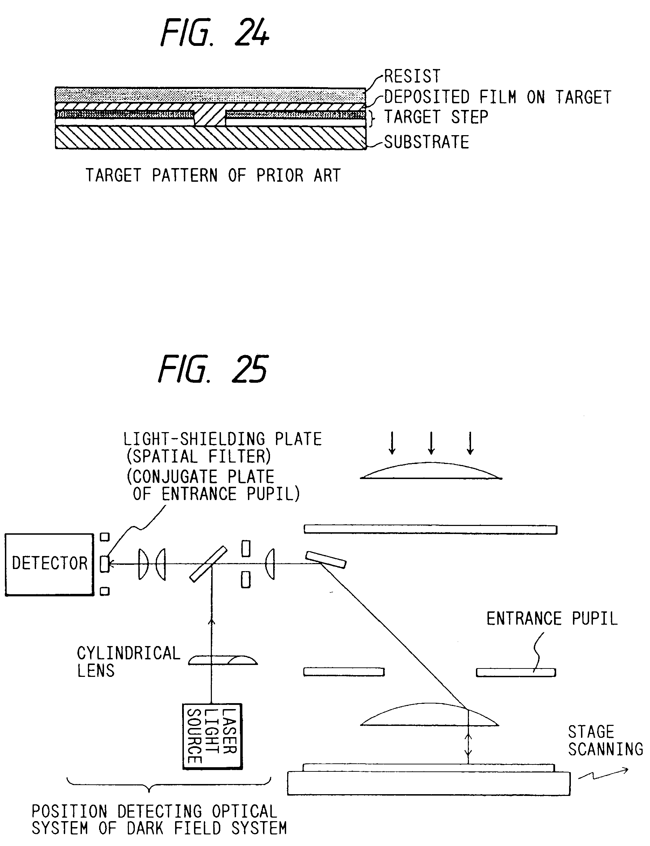

As the target pattern inserting method of the prior art, as shown in Fig. 24, there is used a method by which a target pattern is transferred to he plain region of a multi-layered film and is stepped by the etching. On this target step, there is further deposited a multi-layered film, which is coated with a resist film. This target pattern may be disabled to produce a sufficient detection signal by the influences of the optical interference on the multi-layered film and the asymmetry on the step of the coating resist film.

In case of the detection signal is insufficient, there arises a problem that a highly precise alignment cannot be effected.

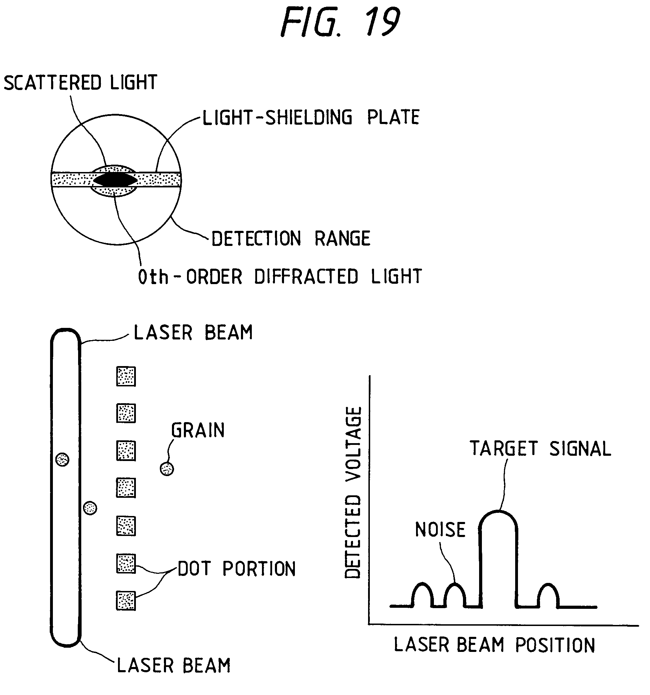

The projecting exposure apparatus for alignment by a dark field type detecting optical system is constructed, as shown in Fig. 25, to include a projection lens for projecting a pattern, an XY stage, and a dark field detecting optical system for recognizing the position of the pattern. A slender laser beam spot is guided to irradiate a target pattern (having a plurality of square recess dot portions arrayed at a predetermined pitch in the longitudinal direction of the spot of the laser beam) on the wafer, as shown in Fig. 19. The 0-th order light, which is produced by a light-shielding plate (or spatial filter) arranged in the conjugate plane of the entrance pupil just upstream of a detector, is cut to detect the diffracted lights other than the 0-th order one produced by the target pattern. These diffracted lights thus detected are stored in a memory, and their signals are processed to recognize the position of the target pattern highly precisely.

In the case of the dark field type detection, the laser beam has its spot position fixed, and the target pattern is scanned by moving the wafer. As a result, this detection is advantageous in that it is reluctant to receive the influences of aberrations of the detecting optical system, but is troubled by a problem that the target pattern shown in Fig. 19 has its alignment precision deteriorated by the influences of the coverage asymmetry of the film on the step or a slight roughness (or grain) around the target pattern.

In Japanese patent Laid-Open No. 192324/1983, on the other hand, there is disclosed an alignment pattern which is formed of a fine pattern for increasing the contrast from the periphery by the irregular reflection on a half plane.

For attaining a high alignment precision in the bright field detecting optical system, an accurate adjustment is required eliminate the errors such as the optical aberrations of the detecting optical system or the misalignment of the detecting illumination optical axis. The errors of the detecting optical system are represented by the following ones which will deteriorate the detection precision:

(1) Misalignment of the detecting illumination optical axis;
(2) Error of the focal point;
(3) Coma of the detecting optical system; and
(4) Color aberration of the detecting optical system.

An object of the present invention is to permit a technique capable of adjusting a position detecting optical system highly precisely by discriminating the factors of error such as the coma or the misalignment of the illumination optical axis to be achieved.

For achieving a highly precise alignment, there may be required a signal processing method which is hardly influenced by the errors such as the optical aberrations of the position detecting optical system or the misalignment of the detecting illumination optical axis. However, the aforementioned symmetric processing method takes a low Z(j) value even in case no waveform is within the integration range, so that a number of minimal values appear to cause the misunderstanding.

On the other hand, it is difficult to compare and evaluate the absolute value of symmetry of the waveform.

Another object of the present invention is to provide a signal processing technique which may be capable of comparing and evaluating the absolute value of symmetry of the waveform with little misunderstanding.

In order to align the wafer highly precisely, on the other hand, it is preferable to insert the target pattern which can produce a signal having excellent contrast and symmetry.

A sufficient detection signal may not be produced from the target pattern by the influences due to the optical interference on the multi-layered film or the influences due to the asymmetry of the deposited multi-layered film or the applied resist film on the step. In this case, a highly precise alignment may not be effected.

An object of the present invention is to provide a target pattern from which a position detection signal having excellent contrast and symmetry may be produced in the bright field type detecting optical system.

In order for the dark field type detecting optical system to attain a highly precise alignment, it is preferable to reduce the influences of the coverage asymmetry of the film on the step of the target pattern and the roughness (or grain) around the target pattern. On the step of the target pattern, there is formed a film of $SiO_2$, poly-Si or metal. This film is further coated with a resist film. These films are prepared by the CVD, sputtering or rotational application method but cannot be made completely symmetric on the step. This asymmetric target pattern step establishes an asymmetry of the detection signal waveform or a misalignment so that the detection precision is deteriorated.

On the other hand, the deposited film of metal or the like has its surface slightly roughed (in grain) to deteriorate the S/N ratio of the detection signal waveform and accordingly the detection precision.

An object of the present invention is to provide a target pattern which permits the detection of a position highly precisely by reducing the influences of the coverage asymmetry of the film on the target pattern step in the dark field type detecting optical system.

A further object of the present invention is to provide a target pattern which permits the detection of a position highly precisely by reducing the influences of the grain around the target pattern in the dark field type detecting optical system.

A further object of the present invention is to provide an exposure technique which permits the transferring of a pattern highly precisely.

The foregoing and other objects and novel features of the present invention will become apparent from the following description to be made with reference to the accompanying drawings.

A representative of the invention to be disclosed herein will be summarized in the following.

The graphic signal waveform to be detected by the detecting optical system can be approximated by the wave optics theory. The wave (U) of a light is given by the following equation:

$$U = A(t)\exp(\underline{i}\omega t + \underline{i}K\beta) \qquad (3).$$

Here, A(t): the amplitude of the wave of a light source and a function of time (t). Letter $\omega$: an angular velocity of the wave. Moreover, $K = 2\pi/\lambda$, and $\lambda$: a wavelength. Letter $\beta$: an optical path difference. A light emitted from an identical point can be considered to have a constant amplitude independently of the time and can be handled by the following equation:

$$U = A\exp(\underline{i}K\beta) \qquad (4).$$

In case the pattern surface is irradiated with parallel lights, the reflected lights have different intensities and phases dependent upon the pattern surface. These reflected lights interfere with each other to focus a Fourier transformed image on the pupil plane of the detecting optical system. This Fourier transformed image (F) is given by the following equation:

$$F(\Theta x, \Theta y) = \int M(x,y)\exp(\underline{i}K\beta)dxdy \qquad (5).$$

Here, M(x,y): a reflected light from the pattern surface and a function of a complex number. Letter $\beta$: an optical path difference and a function of $\Theta x$, $\Theta y$, x and y. Moreover, $K = 2\pi/\lambda$, and $\lambda$: a wavelength. This integration has to be carried out for the necessary area of the pattern surface.

The light having passed over the pupil plane of the detecting optical system is focused on the image plane through the lens. The wave (W) of the focused light is given by the following equation:

$$W(x,y) = \int F(\Theta x, \Theta y) \exp(\underline{i}K\beta) d\Theta d\Theta \qquad (6).$$

Here, $F(\Theta x, \Theta y)$: a Fourier transformed image on the pupil plane and a function of a complex number. Letter $\beta$: an optical path difference and a function of $\Theta x$, $\Theta y$, x and y. Moreover, $K = 2\pi/\lambda$, and $\lambda$: a wavelength. This integration has to be carried out for the area on the pupil plane.

The intensity of the focused light is a square of waves. In case, moreover, the illumination light source has a finite size, its intensity can be determined as an average by assuming that the individual light source points have no coherence.

In case the detecting optical system has aberrations, the optical intensity can be determined by operating the function of the optical path difference $\beta$.

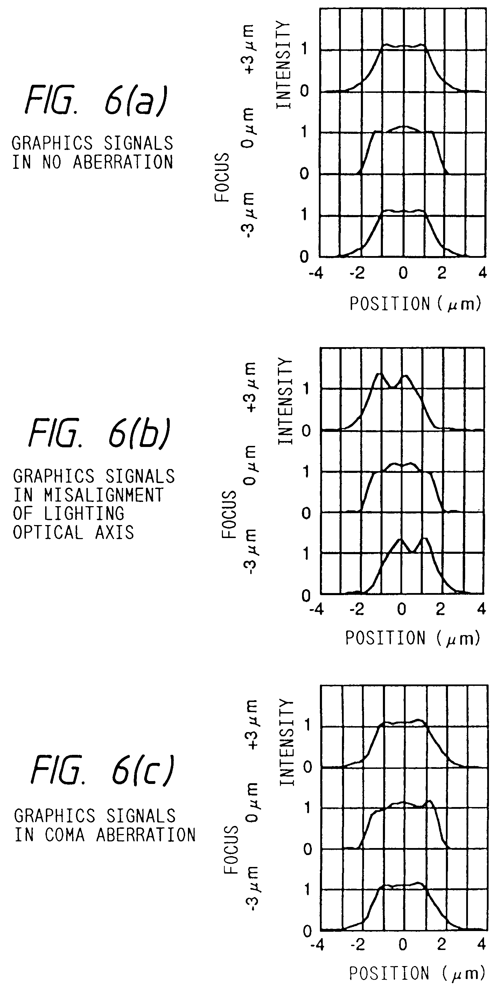

Fig. 5(a) shows an ideal target pattern in the bright field type detecting system. In this target pattern, only the target pattern portion has a reflectivity of 100%, and its surrounding has a reflectivity of 0%. As a matter of fact, it is difficult to form such target pattern on the wafer. According to the present invention, however, it is possible to form a target pattern capable of producing graphic signals similar to the ideal one. This is one means for solving the problems.

The waves on the pupil plane, as determined from the ideal target pattern shown in Fig. 5(a) by using the wave optics theory, are illustrated in Fig. 5(b).

Moreover, the graphic signals obtained by an ideal bright field type detecting optical system are illustrated in Fig. 6(a). If the bright field type detecting optical system has its illumination optical axis inclined, the graphic signals are illustrated in Fig. 6(b). Likewise, the graphic signals of the case, in which the bright field type detecting optical system have a coma, are illustrated in Fig. 6(c).

In the above calculations, it is set that the waveform $(\lambda) = 633$ nm and the numerical aperture (NA) = 0.52.

In Fig. 6(a), the abscissa indicates the position taken in the detecting direction, and the ordinate indicates the intensity of the light. The calculations are made for the focuses of +3 $\mu$m, 0 $\mu$m and -3 $\mu$m. In the bright field detecting optical system of no aberration, the graphic signals are completely symmetric and are hardly deteriorated to take symmetric shapes even at the defocus time.

In case the illumination optical axis is inclined, as illustrated in Fig. 6(b), the graphic signals are symmetric at the best focused time. At the defocus time, on the other hand, the graphic signals are asymmetric with a misalignment.

In the case of a coma, as illustrated in Fig. 6(c), the graphic signals are asymmetric even at the best focused time. Little influence is caused by the defocus.

Proper operations are required for determine the center position of the pattern and the symmetry of the graphic signals accurately and qualitatively from the aforementioned graphic signals.

The symmetric processing method is generally used as the signal processing of the prior art. In the symmetric processing method, the inconsistency Z(j) of symmetry is calculated for an arbitrary detection reference point (j) thereby to determine the position for minimizing the inconsistency Z(j). The symmetry is calculated by the following equation:

$$Z(j) = \sum_{k=k1}^{k=k2} [G(j-k) - G(j+k)]^2 \qquad (7).$$

Here, k: a variable of integration range of the symmetric processing from k1 to k2, both of which are positive integers. Letter j designates a variable of the detection reference point. In the present method, a symmetric error is determined for the reference point so that a highly precise detection can be achieved if the graphic signal is symmetric. In case, however, the waveform is outside of the aforementioned integration range, the value of the inconsistency Z(j) is so small that a number of minimal values appear, thus raising a problem of a misunderstanding.

Moreover, it is difficult to compare and evaluate the absolute values of symmetry of the waveform.

In the signal processing technique improved by the present invention, the dispersed values of the graphic signals are determined for the integration range from k1 to k2, and the symmetric processing results are normalized by using the dispersed values to solve the aforementioned problems.

A specific processing equation is as follows:

$$V(j) = \sum_{k=k1}^{k=k2} [G(j+k) - G_B(j)]^2 \qquad (8),$$

Here, $G_B$: an average value of G(j+k) for the integration range from k1 to k2.

The normalized symmetric processing result (S) is expressed either by the following equation:

$$S(j) = \frac{Z(j)}{V(j)} \qquad (9),$$

or

$$S(j) = \left[\frac{Z(j)}{V(j)}\right]^{\frac{1}{2}} \qquad (10).$$

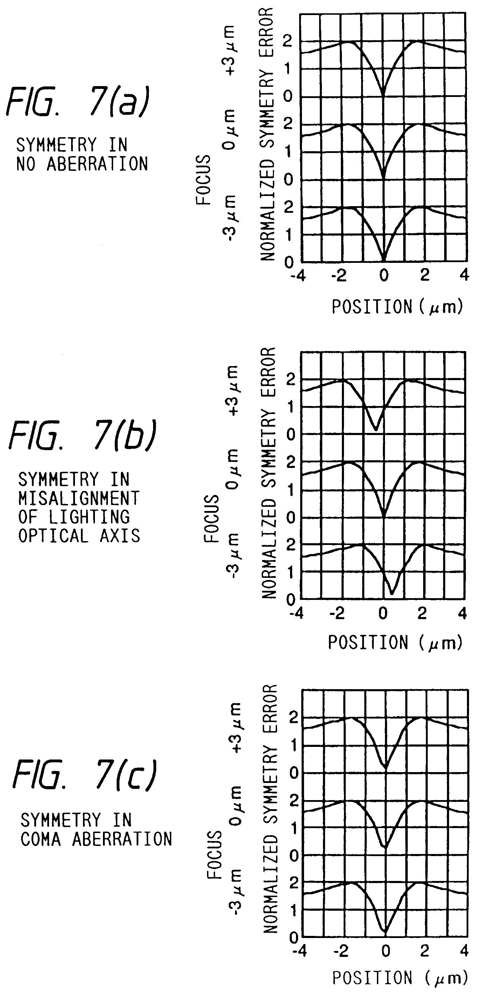

Fig. 7(a) illustrates the result of the normalized symmetric processing of the graphic signals which are obtained by the bright field type detecting optical system in the case of no aberration.

Fig. 7(b) illustrates the result of the normalized symmetric processing of the graphic signals which are obtained by the bright field type detecting optical system in case the illumination optical axis is inclined.

Fig. 7(c) illustrates the result of the normalized symmetric processing of the graphic signals which are obtained by the bright field type detecting optical system in the case of a coma.

Figs. 7(a), 7(b) and 7(c) employ the aforementioned second equation (using the root). If the graphic signals are subjected to the normalized symmetric processing, the symmetric error takes its minimum at the center position of the pattern so that the pattern center position can be easily determined.

In the result of the normalized symmetric processing of the graphic signals which are obtained by the bright field type detecting optical system in the case of no aberration, as illustrated in Fig. 7(a), the symmetric error is zero at the center position of the pattern independently of the focus value. This implies that the graphic signal waveform is completely symmetric.

In the result of the normalized symmetric processing of the graphic signals which are obtained by the bright field type detecting optical system in case the illumination optical axis is inclined, as illustrated in Fig. 7(b), it is indicated that the center position of the pattern is shifted at the defocus time. However, this implies that the symmetry of the graphic signal waveforms is relatively excellent.

In the result of the normalized symmetric processing of the graphic signals which are obtained by the bright field type detecting optical system in the case of a coma, the shift of the center position of the pattern is small, but the symmetric error at the best focused time is large. This implies that the waveform of the graphic signals is asymmetric.

By employing the normalized symmetric processing, it is possible to determined the center position of the pattern accurately and to determine the symmetry of the graphic signal waveform accurately and qualitatively.

In order to align the wafer highly precisely, it is necessary to insert a target pattern capable of producing signals having excellent contrast and symmetry.

The target pattern may be disabled to produce a sufficient detection signal by the influences of the optical interference on the multi-layered film and the asymmetry on the step of the coating resist film. In this case, a highly precise alignment may not be effected.

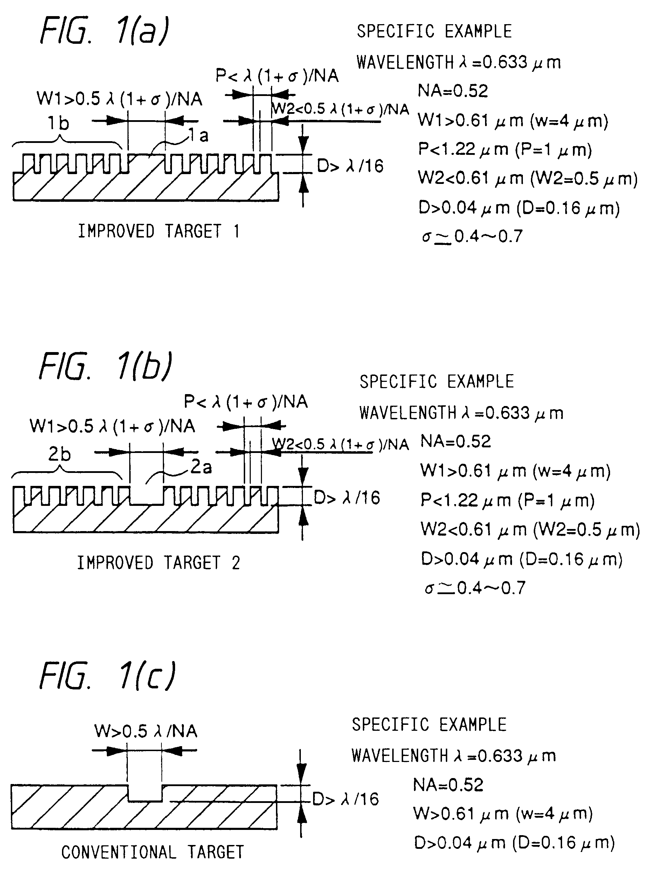

Fig. 1(c) is a section showing a bright field detecting target pattern generally existing in the prior art.

Next, Figs. 1(a) and 1(b) show the target patterns which are equivalent to the bright field detecting ideal target pattern so that they can produce signals having excellent contrast and symmetry.

The improved target patterns of Figs. 1(a) and 1(b) produce equivalent graphic signals in case the upper portion and the lower portion of the step have equal reflectivities. In the ordinary process wafer, however, the upper and lower portions of the step are given different reflectivities by the influences of the thin-film multiplex interference in the multilayered film.

A bright field detecting target pattern 1, as improved in Fig. 1(a), is composed of ridge-shaped line portions or dot portions 1a and repeated step portions 1b arranged around the former portions 1a, and is effective in case the upper portion of the step has a higher reflectivity.

A bright field detecting target pattern 2, as improved in Fig. 1(b), is composed of recessed line portions or dot portions 2a and repeated step portions 2b arranged around the former portions 2a, and is effective in case the bottom portion of the step has a higher reflectivity.

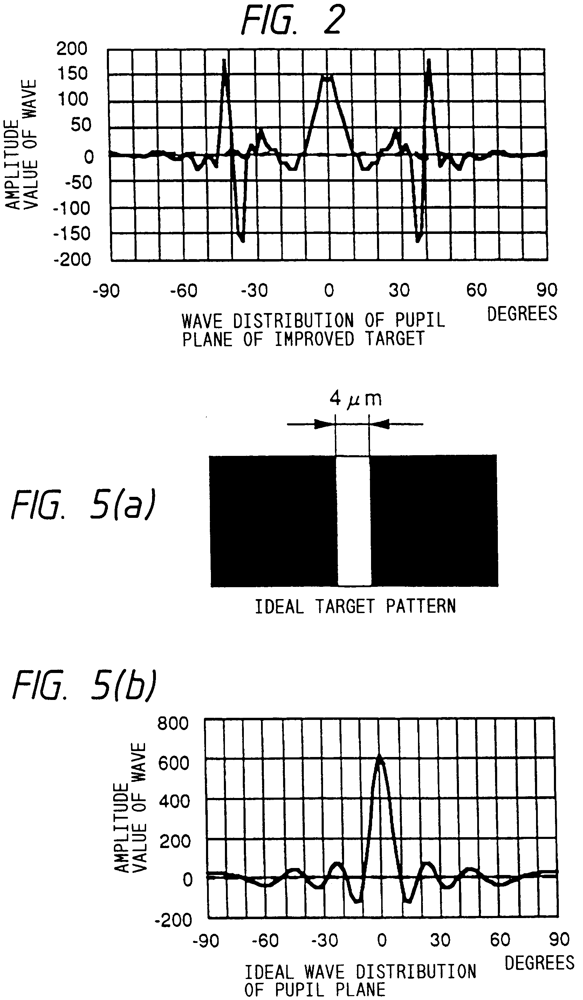

Fig. 2 illustrates the wave distribution of a pupil plane in case the upper and lower portions of the step have equal reflectivities.

The aforementioned wave distribution of the ideal pupil plane of Fig. 5(b) and the wave distribution of the pupil plane of the improved target of Fig. 2 apparently seem to fail to resemble each other, if compared. If, however, the NA = 0.52 of the optical system is considered, only the waves having an angle within ±30 degrees are effective, and the two wave distributions are similar if the angle is restricted within that range.

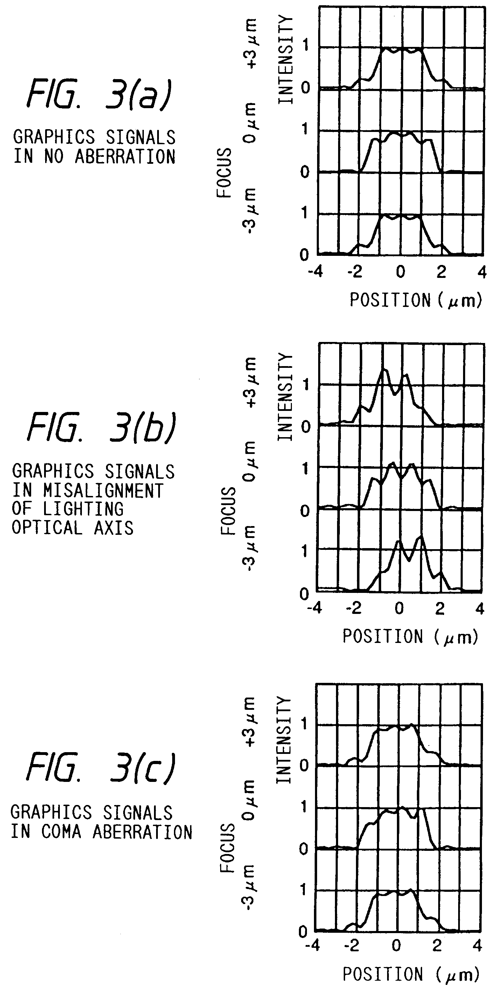

As to the improved target pattern: Fig. 3(a) illustrates graphic signals in case the bright field type detecting optical system has no aberration; Fig. 3(b) illustrates graphic signals in case the bright field type detecting optical system has an alignment in its illumination optical axis; and Fig. 3(c) illustrates graphic signals in case the bright field type detecting optical system has a coma.

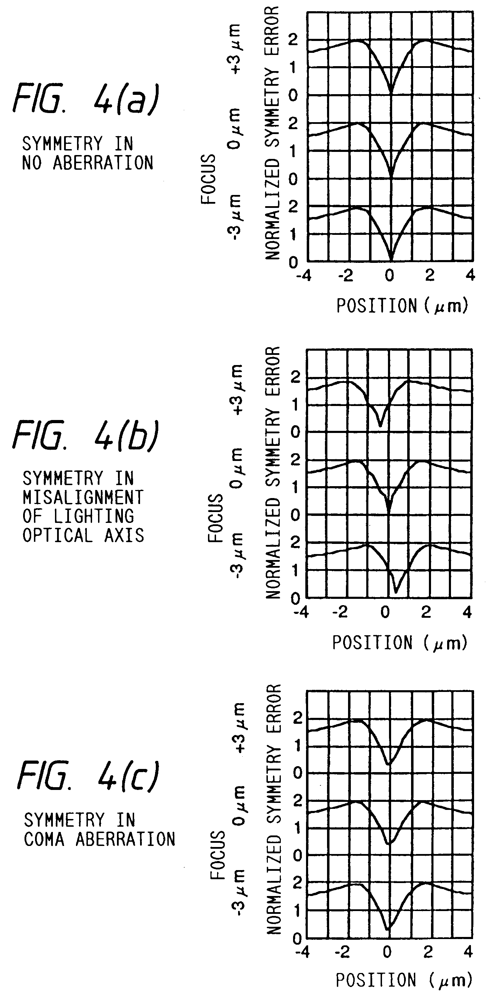

On the other hand: Fig. 4(a) illustrates a normalized symmetry in case the bright field type detecting optical system has no aberration; Fig. 4(b) illustrates a normalized symmetry in case the bright field type detecting optical system has a misalignment in its illumination optical axis; and Fig. 4(c) illustrates a normalized symmetry in case the bright field type detecting optical system has a coma.

It is found that the ideal bright field detecting target pattern of Fig. 5(a), the improved bright field detecting target pattern 1 of Fig. 1(a), and the improved bright field detecting target pattern 2 of Fig. 1(b) are substantially similar in the shapes of the graphic signals obtained and the in the shapes after the normalized symmetric processing. As a result, a highly precise alignment can be achieved in the bright field type detecting optical system.

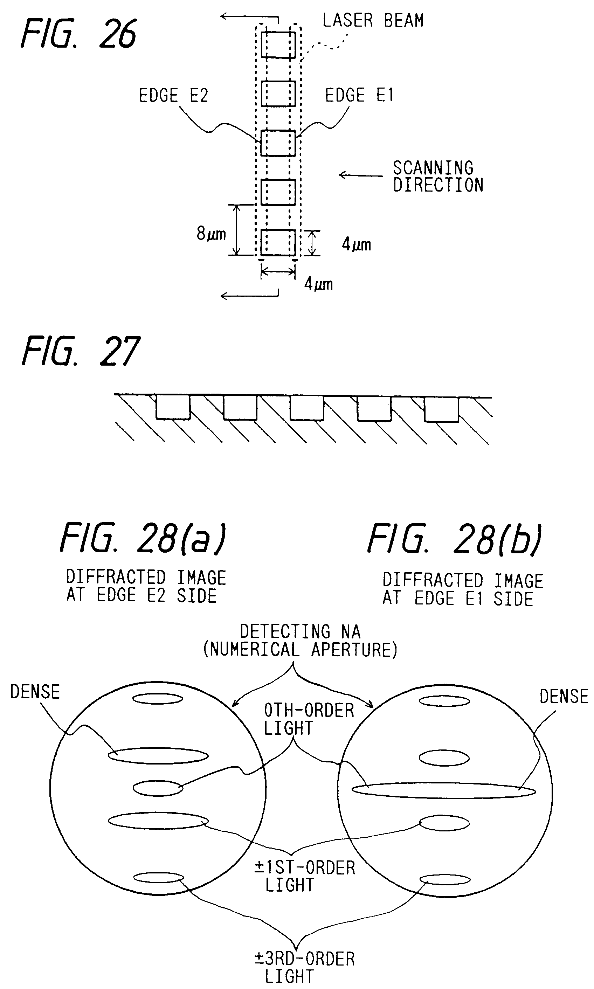

Fig. 26 is a top plan view showing a standard target pattern of a dark field detecting type, and Fig. 27 is a section showing a portion taken in the direction of arrows A - A of Fig. 26. If this target patter is irradiated with a laser beam, this beam is reflected by the upper face and the lower face of the step of the pattern so that the reflected lights are given a phase difference by the step depth. The lights reflected by the upper and lower faces of the step interfere each other to form diffracted images, as shown in Figs. 28(a) and 28(b), on the pupil plane of the detecting optical system. These diffracted images have their optical intensity distributions and intensities varied by the intense influences of the phase difference of the reflected lights between the upper and lower faces due to the step depth.

With an asymmetry of the coverage (at the individual edges E1 and E2 in the scanning direction) of the film formed on the step, this step depth turns asymmetric (to indicate the diffracted images to be detected when the laser beam passes over the edges El and E2 during the scanning operation, as shown in Figs. 28(a) and 28(b)) in accordance with the scanning of the laser beam irradiating position. As a result, the detection signal waveform turns asymmetric to deteriorate the detection precision. This asymmetry of the step portion is generally liable to occur on the lower faces of the recesses. This is because the step is shadowed by the etching irregularity and a portion of the recess at the sputtering time.

The target pattern of the prior art detects the diffracted images which are formed by irradiating substantially the same areas of the upper and lower faces of the step with a laser beam.

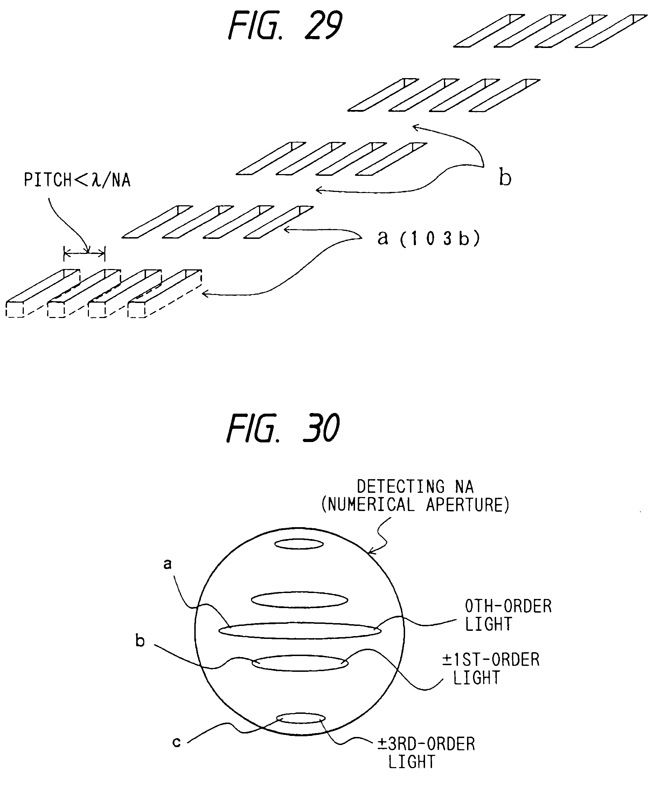

A dark field detecting target pattern improved by the present invention is shown in Fig. 29. A plurality of portions a (i.e., dot portions: repeated step portions 104b) are individually formed of line-shaped corrugated patterns having a pitch size no more than $\lambda/NA$, if the detecting system has a numerical aperture NA and a detection wavelength $\lambda$. The portions a (or the dot portions) leave flat portions b inbetween. If this pattern is irradiated with a laser beam, the lights are reflected by the portions a (or the dot portions) to form diffracted images outside of the iris of the detection NA so that they make no effective contribution to the detection. As a result, the diffracted images of the lights reflected by the portions b are intensified to produce a diffracted image, as shown in Fig. 30.

In Fig. 30: letter a designates a 0-th order light; letter b designates a 1st-order light; and letter c designates a 3rd-order light. The 0-th order light is cut by the spatial filter of Fig. 25 so that the 1st-order light and the 3rd-order light are mainly detected.

Since the portions b of Fig. 29 are flattened, they are not influenced by the asymmetry of the coverage of the film formed on the step so that the position can be highly precisely detected.

Fig. 19 illustrates a detection signal in case a target formed of a deposited film of metal and having a grain is detected by the dark field type detecting optical system. In case only a flat portion having no pattern is irradiated with the laser beam, the reflected light is limited to the 0-th order diffracted light. Since this 0-th order light is cut by the light-shielding plate, the detected voltage is substantially zero. When the target pattern on the wafer is moved by moving the XY table, the grain is irradiated with the laser beam. Then, the angle of reflection is changed by the grain so that the 0-th diffracted light takes a divergence. As a result, a complete shielding cannot be effected by the light-shielding plate so that the light leaks out to produce a noise signal. When the XY table is further moved to irradiate the target pattern with the laser beam, a normal diffracted image is formed to produce the target signal.

As the ratio (i.e., S/N ratio) of the target signal to the noise signal increases, the detection precision deteriorates.

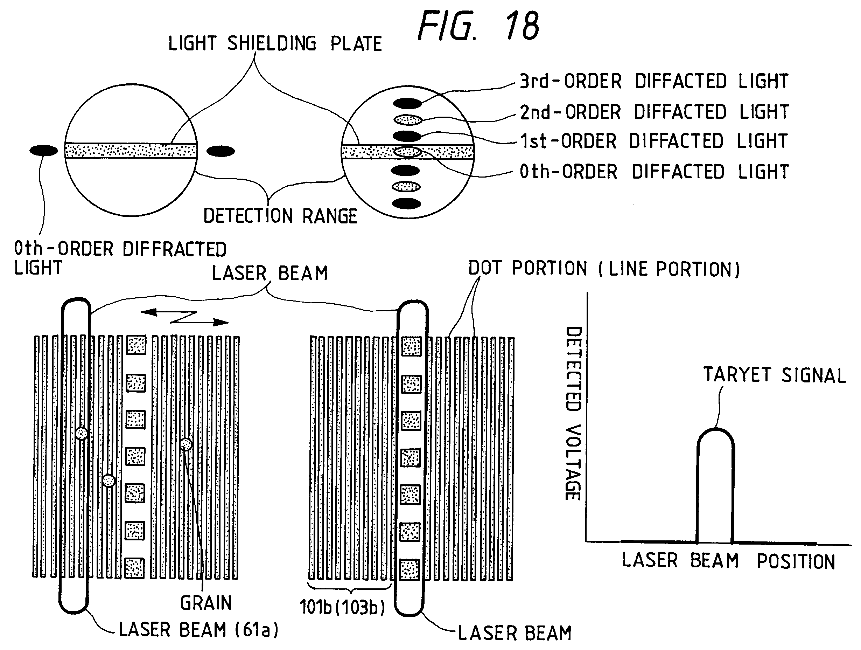

The dark field detecting target pattern improved by the present invention is shown in Fig. 18. This target pattern of Fig. 18 is prepared by forming repeated step portions 103b around a plurality of dot portions 103a. The repeated step portions of Fig. 18 are formed into a line-shaped corrugated pattern having a pitch size no more than $\lambda/NA$ if the detecting system has an aperture NA and a detection wavelength $\lambda$. When this pattern is irradiated with a laser beam, the lights are reflected by the repeated step portions 103b to form diffracted images outside of a detection NA iris so that the detection voltage is substantially zero.

In case the repeated step portions have a grain, the angle of reflection changes due to the grain so that the diffracted image takes a divergence. However, no light will leak because the diffracted image is located outside of the detection NA iris. As a result, no noise is produced by the grain so that a highly precise position detection can be effected.

The representative items inclusive in the invention will be summarized in the following.

1. A signal processing method in a position detecting optical system for fetching a graphic signal G(i) of a target pattern corresponding to the position (i) of a pixel, to effect graphic processing and alignment, characterized in that an inconsistency S(j) of a normalized symmetry is calculated for an arbitrary detection reference point (j) by the following equation (1) to locate a position, in which the inconsistency S(j) of said symmetry takes the minimum, to determined it as a center position of said target pattern, so that the minimum of the inconsistency S(j) of said symmetry may be qualitatively evaluated as the asymmetry of said graphic signal:

$$S(j) = \left[ \frac{\sum\limits_{k=k1}^{k=k2} [G(j-k) - G(j+k)]^2}{\sum\limits_{k=k1}^{k=k2} [G(j+k) - G_B(j)]^2} \right]^{1/m} \quad (1),$$

wherein k: the range of integration of the symmetric processing from k1 to k2, $G_B(j)$: an average value of $G(J+k)$ from the integration range from k1 to k2, and m: an arbitrary integer.

2. A method of adjusting a position detecting optical system for detecting the image of a target pattern formed on an object by using an inspection line having a wavelength $\lambda$, characterized in that the error factors in said position detecting optical system such as a coma or an illumination optical axis inclination are discriminated by setting $(\lambda/4) + (N\lambda/2)$ or $(\lambda/8) + (N\lambda/2)$ when said target pattern on said object has a step size D and if letter N designates an arbitrary integer.

3. A position detecting optical system adjusting method as set forth in item 2, characterized in that the existence and degree of said coma is qualitatively decided on the basis of the magnitude of the inconsistency S(j) of said symmetry in said graphic signal by setting the step size D of said target pattern to $(\lambda/4) + (N\lambda/2)$ and by processing the graphic signal of said target pattern by the signal processing method as set forth in Claim 1.

4. A position detecting optical system adjusting method as set forth in item 2, characterized in that the existence and degree of said illumination optical axis inclination is qualitatively decided on the basis of the magnitude of the inconsistency S(j) of said symmetry in said graphic signal by setting the step size D of said target pattern to $(\lambda/8) + (N\lambda/2)$ and by processing the graphic signal of said target pattern by the signal processing method as set forth in item 1.

5. A target pattern formed on an exposure object, to which is transferred the pattern of an original through an exposing optical system, and used for aligning said exposure object with said original when detected by an aligning position detecting optical system, characterized in that it is formed of repeated steps having such a pitch and a width size as are dissolved by said exposing optical system but not by said position detecting optical system.

6. A target pattern formed on an exposure object, to which is transferred the pattern of an original through an exposing optical system, and used for aligning said exposure object with said original when detected by an aligning position detecting optical system, characterized in that it is formed therearound with repeated steps having such a pitch and a width size as are dissolved by said exposing optical system but not by said position detecting optical system.

7. A target pattern formed on a semiconductor wafer and used for aligning said semiconductor wafer when detected by a bright field type position detecting optical system having a detection wavelength $(\lambda)$, a numerical aperture (NA) and a partial coherency $(\sigma)$, characterized in that said target pattern is formed of lines or dots having ridge or recess flat portions of a width more than $0.5\lambda (1 + \sigma)/NA$ and is formed therearound with corrugated line-shaped or dot-shaped repeated steps having a pitch size less than $\lambda (1 + \sigma)/NA$ and a step size no less than $\lambda/16$.

8. A target pattern as set forth in item 7, characterized in that it is formed, in case its corrugations have a higher reflectivity at their top portions than at the bottom portions, of: line portions having flat portions of the ridges of a width no less than $0.5\lambda (1 + \sigma)/NA$; and corrugated line-shaped or dot-shaped repeated step portions having a pitch size less than $\lambda (1 + \sigma)/NA$ and a step size no less than $\lambda/16$.

9. A target pattern as set forth in item 7, characterized in that it is formed, in case its corrugations have a higher reflectivity at their bottom portions than at the top portions, of: line portions having flat portions of the recesses of a width no less than $0.5\lambda (1 + \sigma)/NA$; and corrugated line-shaped or dot-shaped repeated step portions having a pitch size less than $\lambda (1 + \sigma)/NA$ and a step size no less than $\lambda/16$.

10. A target pattern formed on a semiconductor wafer and used for aligning said semiconductor wafer when detected by a bright field type position detecting optical system having a detection wavelength $(\lambda)$, a numerical aperture (NA) and a partial coherency $(\sigma)$, characterized in that it is formed of corrugated line-shaped repeated steps having a pitch size less than $\lambda (i + \sigma)/NA$.

11. A target pattern formed on a semiconductor wafer and used for aligning said semiconductor wafer when detected by a bright field type position detecting optical system having a detection wavelength $(\lambda)$ and a numerical aperture (NA), characterized in that it is formed of a plurality of dots arrayed at a desired pitch in a predetermined direction and each composed of corrugated repeated steps having a pitch size less than $\lambda/NA$.

12. A target pattern formed on a semiconductor wafer and used for aligning said semiconductor wafer when detected by a bright field type position detecting optical system having a detection wavelength $(\lambda)$ and a numerical aperture (NA), characterized in that it is formed of: a plurality of dot portions arrayed at a desired pitch in a predetermined direction; and corrugated line-shaped or dot-shaped repeated steps arrayed around said dot portions and having a pitch size less than $\lambda/NA$ and a step size no less than $\lambda/16$.

13. A target pattern formed on a semiconductor wafer and used for aligning said semiconductor wafer when detected by a bright field type position detecting optical system having a detection wavelength $(\lambda)$ and a numerical aperture (NA), characterized in that it is formed of: a plurality of dots arrayed at a desired pitch in a predetermined direction and each composed of corrugated repeated steps having a pitch size less than $\lambda/NA$; and corrugated line-shaped repeated step portions arrayed around said plurality of said dots and in parallel with the array direction of said dots and having a pitch size less than $\lambda/NA$ and a step size no less than $\lambda/16$.

14. An exposure process in which a desired pattern on a reticle is transferred to a semiconductor wafer through a reducing projection optical system and in which said reticle and said semiconductor wafer are aligned by detecting a target pattern formed on said semiconductor wafer through a position detecting optical system, comprising: a first step of adjusting the misalignment of an illumination optical axis in said position detecting optical system by fetching the graphic signals of a first target pattern, which is sensitive to the misalignment of said illumination optical axis, to inspect the symmetry of the graphic signals by the signal processing method as set forth in item 1; a second step of adjusting the coma in said position detecting optical system by fetching the graphic signals of a second target pattern, which is sensitive to said coma, and by inspecting the symmetry of the graphic signals by the signal processing method as set forth in item 1; a third step of forming said semiconductor wafer with a third target pattern including therein or at the background thereof the repeated steps which have such a pitch and a width as are resolved by said reducing projection optical system but not by said position detecting optical system; a fourth step of aligning said semiconductor wafer with said reticle by using said third target pattern; and a fifth step of transferring the pattern on said reticle to said semiconductor wafer.

15. An exposure process in which a desired pattern on a reticle is transferred to a semiconductor wafer through a reducing projection optical system and in which said reticle and said semiconductor wafer are aligned by detecting a target pattern formed on said semiconductor wafer through a position detecting optical system, comprising: forming a portion of said semiconductor wafer with a target pattern including therein or at the background thereof the repeated steps which have such a pitch and a width as are resolved by said reducing projection optical system but not by said position detecting optical system; and aligning said semiconductor wafer with said reticle by using said target pattern.

16. An exposure process as set forth in item 15, further comprising: forming said target pattern composed of lines or dots having ridge or recess flat portions of a width more than $0.5\lambda (1 + \sigma)$/NA if said position detecting optical system has a detection wavelength $(\lambda)$, a numerical aperture (NA) and a partial coherency $(\sigma)$; and forming corrugated line-shaped or dot-shaped repeated steps having a pitch size less than $\lambda (1 + \sigma)$/NA and a step size no less than $\lambda/16$ around said target pattern.

17. An exposure process as set forth in item 15, characterized: in that if said position detecting optical system is of a dark field type having a detection wavelength $(\lambda)$ and a numerical aperture (NA), said target pattern is composed of a plurality of dots arrayed in one direction; and in that each of said dots is composed of corrugated line-shaped repeated steps having a pitch size less than $\lambda (1 + \sigma)$/NA.

18. An exposure process as set forth in item 17, characterized in that corrugated line-shaped repeated step portions having a pitch size less than $\lambda (1 + \sigma)$/NA and a step size no less than $\lambda/16$ are formed in the background region excepting the gaps between said plurality of dots composing said target pattern.

19. An exposure apparatus comprising: a table for placing a semiconductor wafer thereon; a reticle formed with a desired pattern; a reducing projection optical system for transferring the pattern of said reticle to said semiconductor wafer; and a position detecting optical system for detecting the target pattern formed on said semiconductor wafer, to align said semiconductor wafer with said reticle, characterized in that said position detecting optical system includes a signal processing unit for the signal processing method as set forth in item 1.

20. An exposure apparatus as set forth in item 19, characterized in that the target pattern of said semiconductor wafer includes therein or at its background the repeated steps having such a pitch and a width as are resolved by said reducing projection optical system but not by said position detecting optical system.

In the bright field type detecting optical system, the misalignment of the illumination optical axis is adjusted at first by using the target pattern which is sensitive to the illumination optical axis misalignment. Next, the coma of the position detecting optical system is adjusted by using the target pattern which is sensitive to the coma.

On the other hand, the process wafer is formed with an improved target pattern which is free from the influences of the Illumination optical axis misalignment, the coma and the defocus.

Moreover, a highly precise alignment can be achieved, if the exposure apparatus having its position detecting optical system best adjusted by correcting the coma and the illumination optical axis misalignment is used and if the aforementioned improved target pattern is formed for use on the process wafer.

If, in the dark field type detecting optical system, the aforementioned improved target pattern is formed on the process wafer, a highly precise alignment can be achieved without being influenced by the coverage asymmetry of the film on the step and the grain on the wafer surface.

In the drawings:

Figs. 1(a) and 1(b) are sections showing target patterns for bright field of the present invention, and Fig. 1(c) is a section showing one example of a target pattern of the prior art;
Fig. 2 is a diagram illustrating the wave distribution of a pupil plane in case the upper and lower portions of the steps in the target pattern of the present invention have equal reflectivities;

Figs. 3(a), 3(b) and 3(c) are diagrams illustrating individual graphic signals in the respective cases in which the detecting optical system has no aberration, a misalignment of illumination optical axis and a coma for the target pattern of the present invention;

Figs. 4(a), 4(b) and 4(c) are diagrams illustrating individual normalized symmetries in the respective cases in which the detecting optical system has no aberration, a misalignment of illumination optical axis and a coma for the target pattern of the present invention;

Fig. 5(a) is a section of a bright field type ideal target pattern, and Fig. 5(b) is a diagram illustrating a wave of the target pattern on the pupil plane;

Figs. 6(a), 6(b) and 6(c) are diagrams illustrating individual graphic signals in the respective cases of no aberration, a misalignment of illumination optical axis and a coma for the ideal target pattern;

Figs. 7(a), 7(b) and 7(c) are diagrams illustrating individual symmetries in the respective cases of no aberration, a misalignment of illumination optical axis and a coma for the ideal target pattern;

Fig. 8 is a flow chart showing one example of the operations of the exposure process and apparatus according to one embodiment of the present invention;

Figs. 9(a), 9(b) and 9(c) are diagrams illustrating individual graphic signals in the respective cases of no aberration, a misalignment of illumination optical axis and a coma for the target pattern which is sensitive to the inclination of illumination optical axis;

Figs. 10(a), 10(b) and 10(c) are diagrams illustrating individual symmetries in the respective cases of no aberration, a misalignment of illumination optical axis and a coma for the target pattern which is sensitive to the inclination of illumination optical axis;

Figs. 11(a), 11(b) and 11(c) are diagrams illustrating individual graphic signals in the respective cases of no aberration, a misalignment of illumination optical axis and a coma for the target pattern which is sensitive to the coma;

Figs. 12(a), 12(b) and 12(c) are diagrams illustrating individual symmetries in the respective cases of no aberration, a misalignment of illumination optical axis and a coma for the target pattern which is sensitive to the coma;

Figs. 13(a) and 13(b) are top plan views showing one example of the construction of a target pattern according to one embodiment of the present invention;

Figs. 14(a) and 14(b) are top plan views showing one example of the construction of a target pattern according to one embodiment of the present invention;

Figs. 15(a) and 15(b) are top plan views showing one example of the construction of a target pattern according to one embodiment of the present invention;

Figs. 16(a) and 16(b) are top plan views showing one example of the construction of a target pattern according to one embodiment of the present invention;

Figs. 17(a) and 17(b) are sections showing one example of the state in which the target pattern according to one embodiment of the present invention is formed on the wafer;

Fig. 18 is a conceptional diagram showing one example of the operation of the target pattern according to one embodiment of the present invention;

Fig. 19 is a conceptional diagram showing one example of the operation of the target pattern of the prior art;

Fig. 20 is a conceptional diagram showing one example of the construction of the exposure apparatus to which is applied the exposure process according to the present invention;

Fig. 21 is a conceptional diagram showing one example of the construction of the exposure apparatus to which is applied the exposure process according to the present invention;

Fig. 22 is a conceptional diagram showing one example of the exposure apparatus of the prior art;

Figs. 23(a) and 23(b) are conceptional diagrams showing one example of the adjusting method of an optical system of the prior art;

Fig. 24 is a section showing one example of the sectional structure of the target pattern of the prior art;

Fig. 25 is a conceptional diagram showing one example of the projecting exposure apparatus for alignment by a dark field type detecting optical system;

Fig. 26 is a top plan view showing one example of the dark field type target pattern of the prior art;

Fig. 27 is a top plan view showing one example of the dark field type target pattern of the prior art;

Figs. 28(a) and 28(b) are conceptional diagrams showing one example of the diffracted images which are detected at the individual edge portions of the scanning direction in the dark field type target pattern of the prior art;

Fig. 29 is a perspective view showing a target pattern for the dark field of the present invention; and

Fig. 30 is a conceptional diagram showing one example of the diffracted image which is detected from the target pattern for the dark field of the present invention.

The present invention will be described in detail in the following in connection with its embodiments with reference to the accompanying drawings.

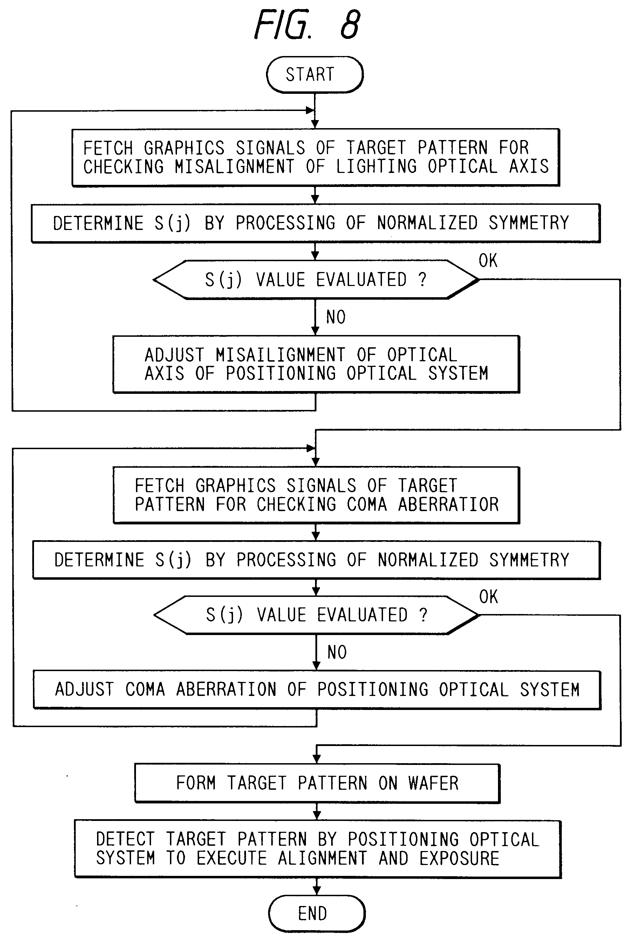

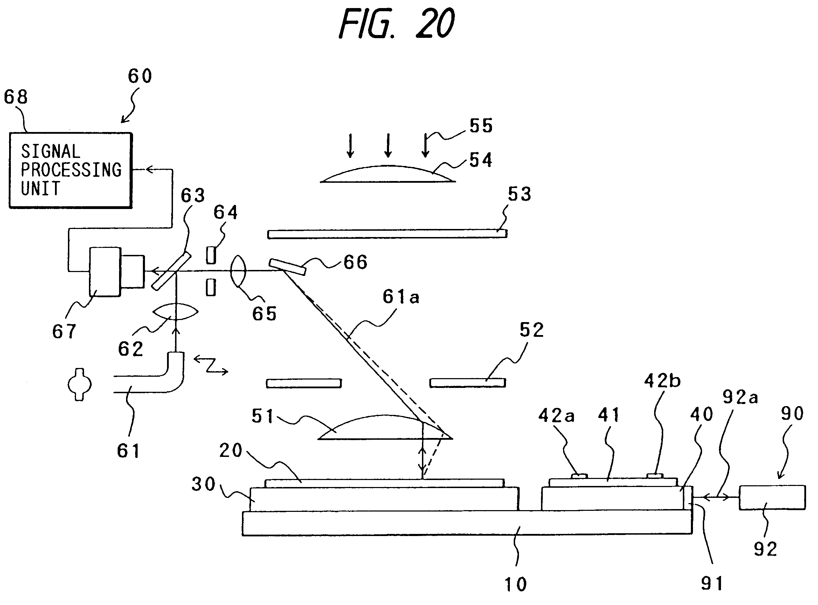

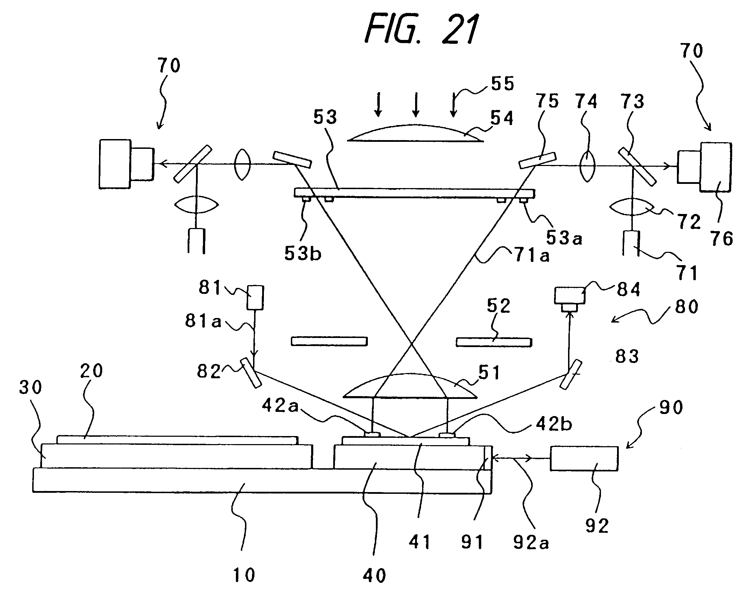

Fig. 8 is a flow chart showing one example of an exposure process according to one embodiment of the present invention in a bright field type detecting optical system, and Figs. 20 and 21 are conceptional diagrams showing one example of the construction of an exposure apparatus to which is applied the exposure process.

First of all, the summary of the exposure apparatus of the present embodiment will be described with reference to Figs. 20 and 21. On a moving state 10 of the present embodiment, there are carried an exposure stage 30, on which is mounted a wafer 20, and a preliminary stage 40. Over the moving stage 10, there is disposed an exposing optical system which is composed of a reducing projection lens 51, an entrance pupil 52, a reticle 53, an exposing illumination lens 54 and so on, as enumerated upward in the recited order. By projecting an exposure light 55 having passed through the reticle 53 in a reduced scale upon the wafer 20, moreover, the exposure is effected to sensitize a resist film formed on the surface of the wafer 20 with a desired pattern.

The exposure apparatus of the present embodiment is constructed to comprise, in addition to the exposing optical system: a position detecting optical system 60 for detecting and aligning the target pattern on the wafer 20; a pair of alignment optical systems 70 for aligning the reticle 53 and the moving stage 10 (or the exposure stage 30), as shown in Fig. 21; and an auto-focusing mechanism 80 for adjusting the focal point of the wafer 20 of the exposing optical system; and a laser measuring mechanism 90 for precisely measuring the displacement of the moving stage (or the exposure stage 30). This laser measuring mechanism 90 is composed of a mirror 91 arranged at the side of the moving stage 10, and a laser source 92 acting as a signal processing mechanism for producing a measuring laser 92a.

The position detecting optical system 60 is composed, as exemplified in Fig. 20, of a light source 61 for emitting a laser of 0.633 $\mu$m as an inspection light 61a, a condenser lens 62, a half mirror 63, a conjugate pupil 64, a relay lens 65, a relay mirror 66 for guiding the inspection light 61a into the entrance pupil 52 and the reducing projection lens 51; an image pickup unit 67, a signal processing unit 68 and so on. Thus, the reflected light of the inspection light 61a, as reflected from the later-described target pattern on the wafer 20, is trapped by the image pickup unit 67 and is subjected to an image processing such as a symmetric processing by the aforementioned Equations (7) to (10), to precisely detect the position of the target pattern.

Incidentally, in the case of a dark field type detecting optical system, the position detecting optical system 60 performs a dark field illumination with a slender laser spot so that the condenser 62 is exemplified by a cylindrical lens. Between the half mirror 63 and the image pickup unit 67, on the other hand, there are interposed a lens for projecting and focusing the conjugate pupil and a light-shielding plate for cutting the 0-th order light of the diffracted light, although not especially shown.

On the preliminary stage 40, there is placed a dummy wafer 41 which is formed with an alignment mark 42a and an alignment mark 42b.

On the other hand, the alignment optical system 70 is composed of a light source 71 for emitting an inspection light such as an i-th line identical to the exposure light 55, a condenser lens 72, a half mirror 73, a relay lens 74, a relay mirror 75 for guiding the inspection light 71a into the exposing optical system through an alignment mark 53a and an alignment mark 53b formed on the reticle 53, an image pickup unit 76 and so on.

As shown in Fig. 21, moreover, the reticle 53 and the wafer 20 on the exposure stage 30 can be precisely aligned by moving the exposing optical system toward the preliminary stage 40 to correct the position of the reticle 53 or the like so that the detected images of the alignment marks 53a and 53b on the reticle 53 and the detected images of the alignment marks 42a and 42b on the dummy wafer 41 may come into alignment, and by storing the positional relation at that time between the exposing optical system (or the position detecting optical system 60) obtained from the laser measuring mechanism 90 and the moving stage 10 (or the exposure stage 30).

The auto focus mechanism 80 is composed of a light source 81 for emitting an inspection light 81a, a relay mirror 82 and a relay mirror 83 arranged in symmetric positions across the optical axis of the exposing optical system for guiding the inspection light 81a onto the dummy wafer 41, a receptor 84 and so on. Thus, when the exposing optical system is in the best focal position with respect to the dummy wafer 41, the exposing optical system is automatically focused relative to the wafer 20 on the exposure stage 30 located in a position equivalent to the dummy wafer 41, by storing such a position of incidence of the inspection light 81a reflected on the dummy wafer 41 as is made upon the receptor 84.

With the exposure apparatus thus constructed, according to the present embodiment, the exposing operations are executed with reference to the flow chart of Fig. 8.

Specifically, the coma of the position detecting optical system 60 and the misalignment of the illumination optical axis are adjusted at first in the following manner.

The target pattern used for checking the misalignment of the illumination optical axis was exemplified by the target of the prior art, as shown in Fig. 1(c). The position detecting optical system 60 used in the present embodiment had the inspection light 61a of an inspection wavelength $\lambda$ = 0.633 $\mu$m and NA = 0.52, and the target pattern was a rectangular line pattern having a width W = 4 $\mu$m $\times$ a length 30 $\mu$m and a recess depth of D = $\lambda$/8 (= 0.08 $\mu$m). Here, this value $\lambda$/8 corresponds to the case in which N = 0 for $\lambda$/8 + N$\lambda$/2 (N: an arbitrary integer).

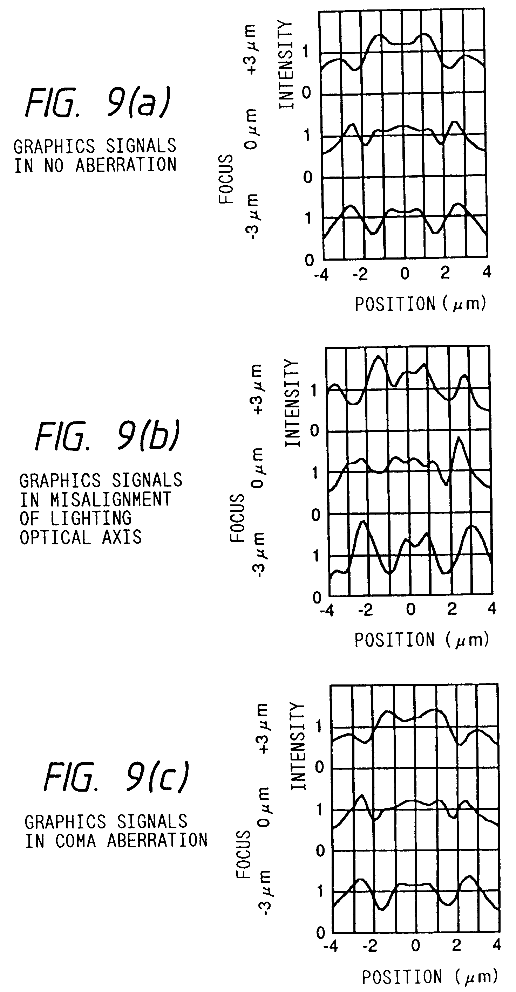

Fig. 9(a) illustrates graphic signals in case the detecting optical system has no aberration; Fig. 9(b) illustrates graphic signals in case the detecting optical system has a misalignment in the illumination optical axis; and Fig. 9(c) illustrates graphic signals in case the detecting optical system has a coma.

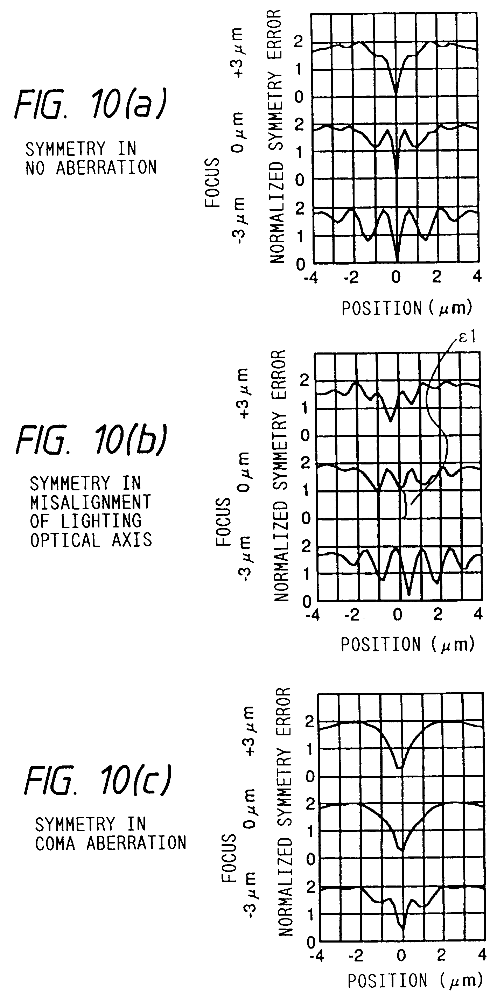

Fig. 10(a) illustrates a normalized symmetry in case the detecting optical system has no aberration; Fig. 10(b) illustrates a normalized symmetry in case the detecting optical system has a misalignment in the illumination optical axis; and Fig. 10(c) illustrates a normalized symmetry in case the detecting optical system has a coma.

The symmetries of the graphic signals in Fig. 10 were evaluated by employing the aforementioned normalized symmetric processing.

The target pattern under the above-specified condition (D = $\lambda/8$ (= 0.08 $\mu$m)) has its normalized symmetric error sensitively increased with respect to the misalignment of the illumination optical axis so that this alignment can be easily checked.

Specifically, the normalized symmetric error $\varepsilon 1$ at the best focal position, as illustrated in Fig. 10(b), can be evaluated to decide that the state of $\varepsilon 1 = 0$ is the state of no misalignment of the illumination optical axis. The position detecting optical system 60 is adjusted to establish that state. Specifically, this adjustment is effected by finely moving the light source 61 in a direction perpendicular to the optical axis in a plane containing the optical path of the inspection light 61a.

The target pattern used for checking the coma was exemplified by the conventional target of Fig. 1(c). The position detecting optical system 60 used in the present embodiment had the inspection light 61a of an inspection wavelength $\lambda = 0.633$ $\mu$m and NA = 0.52, and the target pattern was a rectangular line pattern having a width W = 4 $\mu$m × a length 30 $\mu$m and D = $\lambda/4$ (= 0.16 $\mu$m). Here, this value $\lambda/4$ corresponds to the case in which N = 0 for $\lambda/4 + N\lambda/2$ (N: an arbitrary integer).

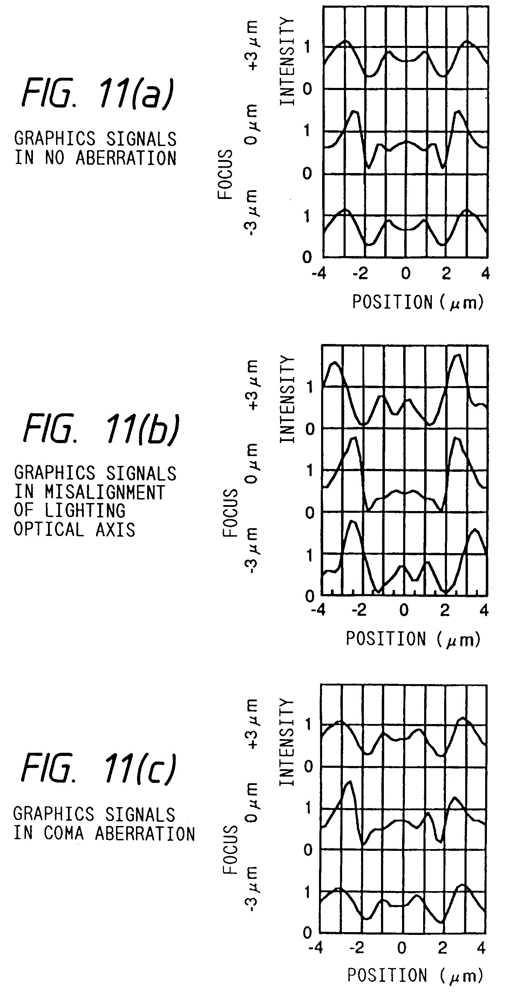

Fig. 11(a) illustrates graphic signals in case the detecting optical system has no aberration; Fig. 11(b) illustrates graphic signals in case the detecting optical system has a misalignment in the illumination optical axis; and Fig. 11(c) illustrates graphic signals in case the detecting optical system has a coma.

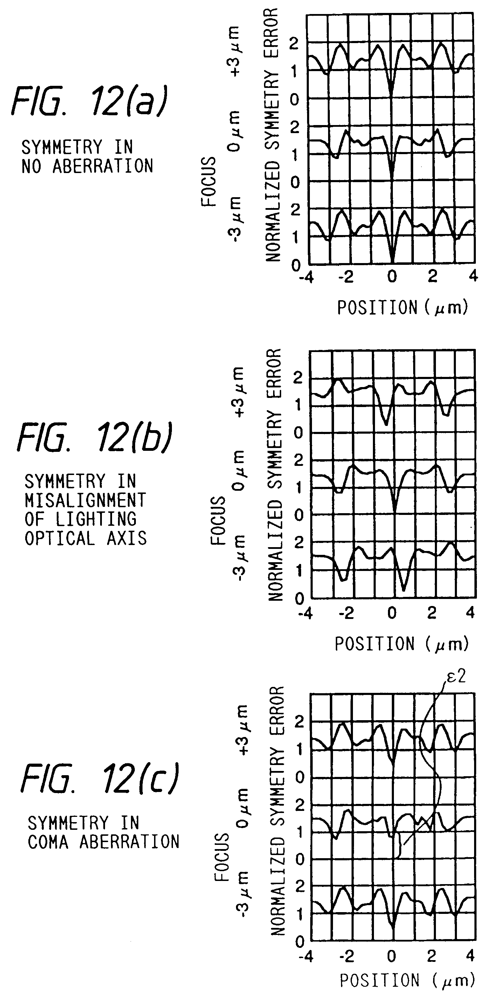

Fig. 12(a) illustrates a normalized symmetry in case the detecting optical system has no aberration; Fig. 12(b) illustrates a normalized symmetry in case the detecting optical system has a misalignment in the illumination optical axis; and Fig. 12(c) illustrates a normalized symmetry in case the detecting optical system has a coma.

The symmetries of the graphic signals in Fig. 12 were evaluated by employing the normalized symmetric processing according to the foregoing Equation (10).

The target pattern under the above-specified condition (D = $\lambda/4$ (= 0.16 $\mu$m)) has its normalized symmetric error sensitively increased with respect to the coma so that this aberration can be easily checked. That is, the normalized symmetric error $\varepsilon 2$ at the best focal position, as illustrated in Fig. 10(b), can be evaluated to decide that the state of $\varepsilon 2 = 0$ is the state of no coma. The position detecting optical system 60 is adjusted to establish that state. Specifically, this adjustment is effected by finely moving the relay lens 65 in a direction normal to a plane containing the optical path of the inspection light 61a.

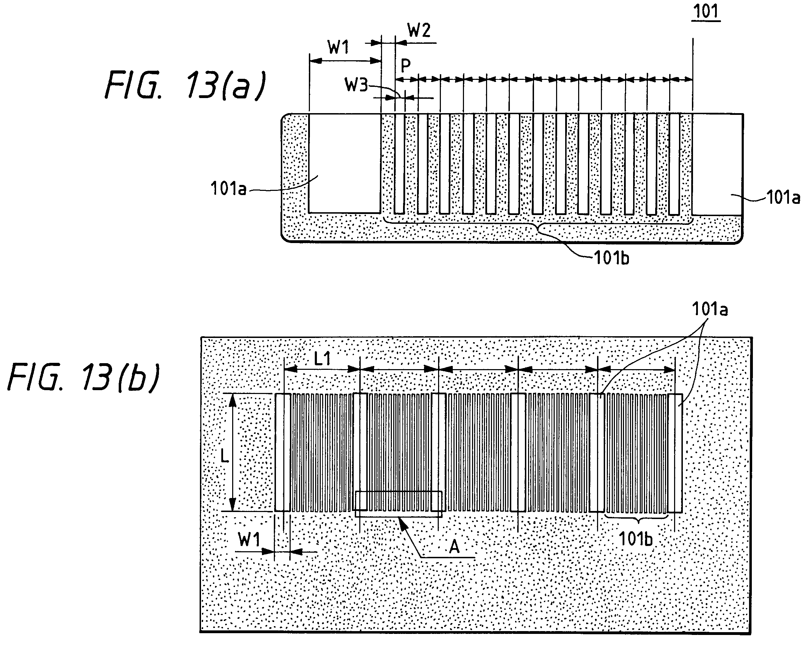

After this adjustment step, the process shifts to the actual exposure step. In the present embodiment, the structure, as exemplified in Fig. 1(b), is used as the target pattern to be formed on the wafer 20. In the bright field detecting system, specifically, the target pattern is given the shape which is exemplified in Fig. 13. Fig. 13(b) is an enlarged top plan view of a target pattern 101, and Fig. 13(a) is a top plan view showing its area A in an enlarged scale.

Incidentally, as in the case of Fig. 1(b), the optical conditions are exemplified by that the inspection light 61a of the position detecting optical system 60 has a wavelength $\lambda = 0.633$ $\mu$m and that the reducing projection lens 51 has an NA = 0.52. Moreover, the partial coherency is $\sigma = 0.4$ to 0.7.

Specifically, the target pattern 101 is constructed, for example, of: a plurality of rectangular line portions 101a having a width W1 = 3.7 $\mu$m (> 0.61 $\mu$m), a length L = 30 $\mu$m and an array pitch L1 = 20 $\mu$m; and repeated step portions formed between the line portions 101a and having a pitch P = 1.2 $\mu$m (< $\lambda$ (1 + $\sigma$)/NA), a recess width W1 = 0.5 $\mu$m (< 0.5(1 + $\sigma$)/NA) and a ridge width W2 = 0.7 $\mu$m (< 0.5 $\lambda$ (1 + $\sigma$)/NA).

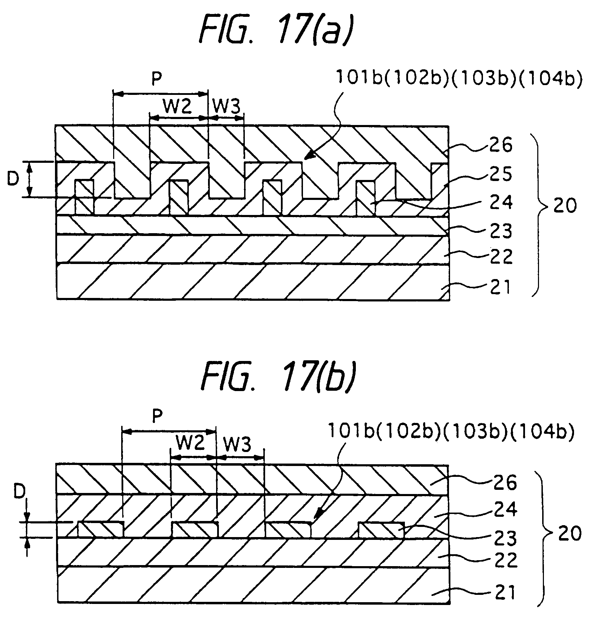

Figs. 17(a) and 17(b) are sections showing one example of the formed state of the wafer 20 of that target pattern 101. Specifically, Fig. 17(a) shows the formed state of the target pattern 101 at a wiring step, and Fig. 17(b) shows the formed state of the target pattern 101 at a holing step.

In Fig. 17(a), there is formed on a substrate 21 of Si or the like a multi-layered film structure which is composed of an insulating film 22 of $SiO_2$, a conducting film 23 of poly-Si or metal, an insulating film 24 of $SiO_2$ or the like, a conducting film 25 of poly-Si or metal, a resist 26 and so on. The insulating film 24 of $SiO_2$ or the like is corrugated to form the conducting film 25 of poly-Si or metal covering the corrugated insulating film 24, into a structure having the repeated step portions 101b.

Likewise in Fig. 17(b), there is formed on the substrate 21 of Si or the like a multi-layered film structure which is composed of the insulating film 22 of $SiO_2$, the conducting film 23 of poly-Si or metal, the insulating film 24 of $SiO_2$ or the like, a resist 26 and so on. The conducting film 23 of poly-Si or metal is corrugated and formed into a structure having the repeated step portions 101b.

Thus, the line portions 101a are bright whereas the repeated step portions 101b are dark so that the graphic signals obtained can have excellent contrast and symmetry, as shown in Fig. 6(a), to detect a position highly precisely.

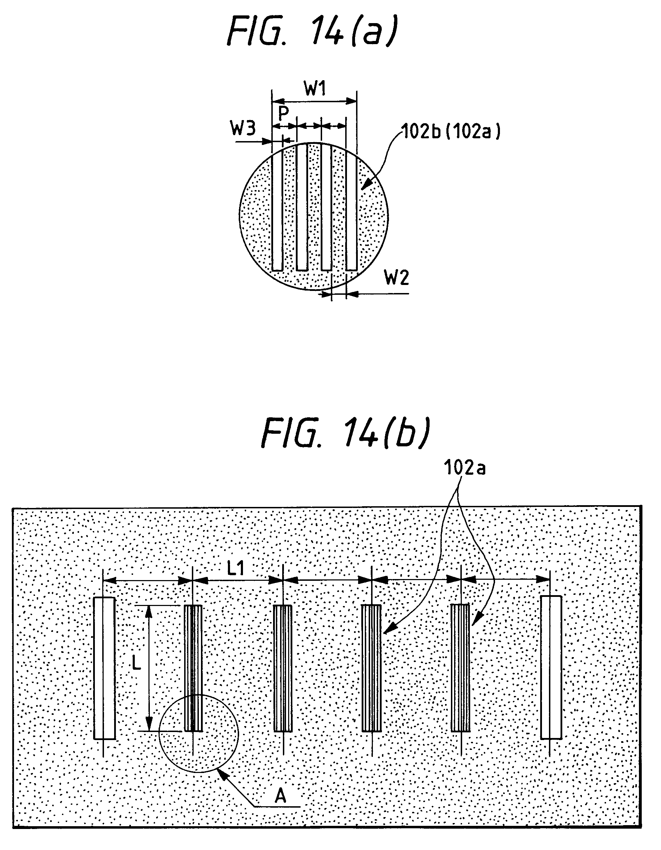

Another target pattern to be specifically used in the bright field detecting system is shown in Fig. 14. Fig. 14(b) is a top plan view of the entirety of a target pattern 102, and Fig. 14(a) is a top plan view showing its area A in an enlarged scale.

In this case of Fig. 14, line portions 102 composing the target pattern 102 are constructed of repeated step portions 102b.

Specifically, the line portions 102a are formed into a rectangular shape having a width W1 = 4.1 $\mu$m and a length L = 30 $\mu$m and are arranged at a pitch L1 = 20 $\mu$m. Each of the line portions 102a is defined by the repeated step portions 102b having a ridge width W2 = 0.7 μm, a recess width W3 = 0.5 μm and a pitch P = 1.2 μm.

In this case, the line portions 102a are darker whereas their peripheries are brighter so that the graphic signals have their brightness and darkness reversed from those of the aforementioned graphic signals of Fig. 13 but have so similarly excellent contrast and symmetry as to effect a highly precise position detection.

The target pattern thus far described is a proper example in the bright field detecting system. In the dark field detecting system, however, the detection principle is different so that the proper target pattern is accordingly different.

This dark field detecting system detects a diffracted light which is produced by a target pattern.

For the scattering angle of the diffracted light, the following conditional equation is obtained:

$$P\sin\theta = n\lambda \qquad (11).$$

Here, P: the pitch of the pattern, θ: the scattering angle of the diffracted light, λ: the inspection wavelength, and n: an arbitrary integer to determine a 0-th order diffracted light for n = 0, a 1st-order diffracted light for n = 1, a 2nd-order diffracted light for n = 2, and an n-th diffracted light for n = n .

A target pattern of the prior art, as shown in Fig. 19, is square patterns having a side of 4 μm and arranged at a pitch of 8 μm. For the detection wavelength λ = 633 nm, the 1st-order diffracted light is produced in the direction of ±4.5 degrees, and the 3rd-order diffracted light is produced in the direction of ±13.7 degrees. The detected NA is about 0.26, and the 0-th order diffracted light is cut by the light-shielding plate, but the 1st-order to 3rd-order diffracted lights are detected.

In this target pattern of the prior art, as already described hereinbefore, the 0-th order diffracted light leaks due to the roughness (or grain) of the wafer surface so that the detection precision is liable to deteriorate.

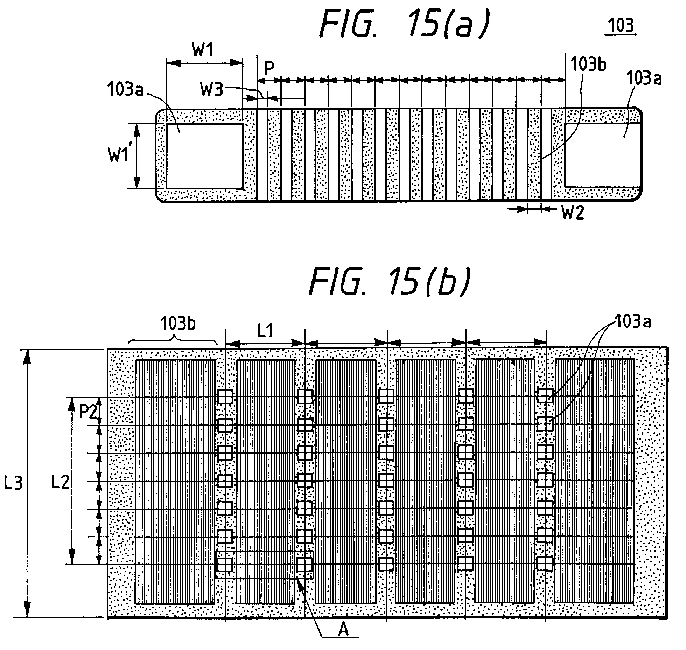

A specific embodiment of the dark field detecting target pattern of Fig. 18 improved by the present invention is shown in Fig. 15. Fig. 15(b) is an enlarged top plan view of a target pattern 103, and Fig. 15(a) is a top plan view showing its area A in an enlarged scale.

In Fig. 15, there is shown the target pattern 103 which is suitable for the case of dark field illumination. Specifically, the target pattern of this case is composed of: a plurality of dot portions 103a arranged at a pitch P2 in a direction perpendicular to the scanning direction of illumination; and repeated step portions 103b arranged around the dot portions 103a.

For example, the dot portions 103a have an array pitch P2 of 8 μm and an array width L2 of about 48 μm. On the other hand, the repeated step portions 103b have a width L3 of 80 μm, as taken in the array direction of the dot portions 103a. The individual dot portions 103a have a rectangular shape of a width W1 3.7 μm × W1' = 4 μm . The sizes P, W2, W3 and so on of the repeated step portions 103b are similar to those of the aforementioned cases of Figs. 13 and 14 (also to the optical conditions).

In this case of Fig. 15, the graphic signals are detected by selectively illuminating with a laser spot having a larger width than W1 and a larger length than L2 and by scanning the target pattern 103 relative to the laser spot and in a direction perpendicular to the array direction of the dot portions 103a. At this time, as exemplified in Figs. 18 and 19, the diffracted lights, which are produced by the noise due to the grains or the like existing around the dot portions 103a, are out of the detection range so that the dot portions 103a of the target pattern 103 can be clearly detected.

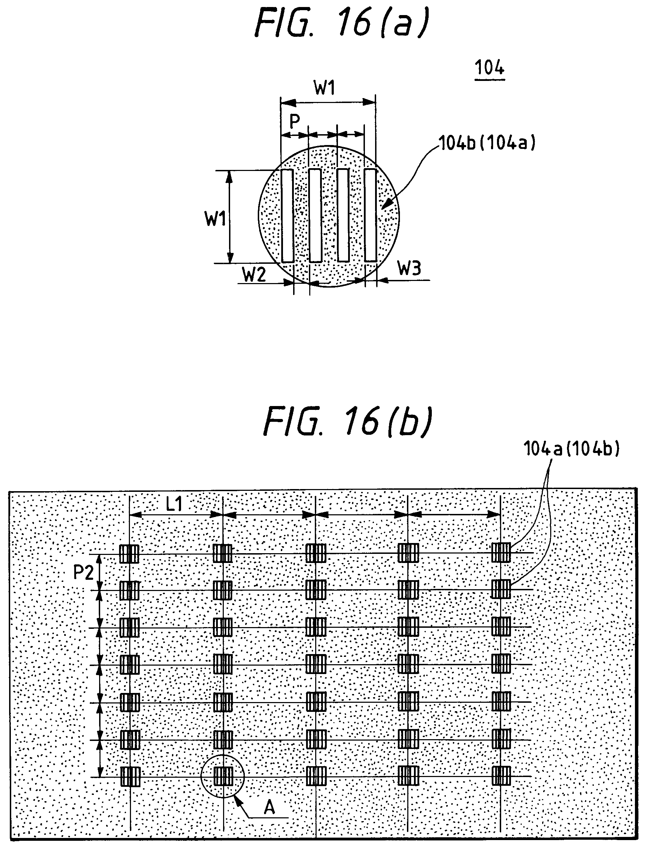

A specific embodiment of the dark field detecting target pattern of Fig. 29, as improved by the present invention, is shown in Fig. 16. Fig. 16(b) is an enlarged top plan view of a target pattern 104, and Fig. 16(a) is a top plan view showing its area A in an enlarged scale.

In this case of Fig. 16, the target pattern 104 has its dot portions 104a formed of repeated step portions 104b, which have dimensions (P, W2 and W3) equal to those of Fig. 15.

In case the repeated step portions 104b are formed of the construction, as exemplified in Fig. 17(a), on the wafer 20, the diffracted lights emitted from the repeated step portions 104b forming the dot portions 104a go out of the range of the detection field so that they are not detected, but only the diffracted lights from the flat portions between the dot portions 104a are detected. As a result, the influences of asymmetry of the coverage of the individual dot portions 104a with the corrugated thin film are eliminated so that the symmetry of the detected signals at the edge portions are improved better than the case in which simple recesses or ridges are formed, to reduce the dispersion (or asymmetry) of the detected signals at the individual edge portions, as exemplified in Figs. 28(a) and 28(b). As a result, the target pattern 104 can be highly precisely detected to make contribution to an improvement in the alignment precision for the reticle 53 of the wafer 20, as made by using that target pattern 104.

Although not especially shown, on the other hand, there may be made a combination with a technique for forming the dot portions 104a constructed by the repeated step portions 104b, as exemplified in Fig. 16, and the repeated step portions 103b, as exemplified in Fig. 15, on the background of the dot portions 104a. According to this technique, it is possible to make compatible the improvement in the symmetry of the detected signals at the edge portions and the improvement in the S/N ration by preventing the leakage of the 0-th order light due to the grains on the background.

Thus, the resist 26 on the wafer 20 can be precisely exposed to a desired pattern by detecting the target patterns 101, 102, 103, 104 and so on, which are formed on the wafer 20, by the position detecting optical system 60 to align the wafer 20 highly precisely with the reticle 53, and by irradiating the resist 26 on the wafer in the aligned state through the reducing projection lens 51 with the exposure light 55 which has passed through the reticle 53.

According to our experiments, it has been found that the following effects can be achieved by the technique of the present embodiment.

(1) The bright field type position detecting optical system 60 could have its illumination optical axis misalignment error reduced to one half or less.

(2) The bright field type position detecting optical system 60 could have its coma error reduced to one half or less.

(3) The erroneous detection percentage of the center position of the target pattern could be reduced to one half or less, as compared with the symmetric processing of the prior art.

(4) The alignment error could be reduced to about one half, as compared with the target patter of the prior art.

(5) The integration and yield were improved by applying the technique of the present embodiment to a manufacture process of an LSI.

Although our invention has been specifically described in connection with its embodiments, it should not be limited thereto but can naturally be modified in various manners without departing from the gist thereof.

For example, the foregoing embodiments have been described by taking up the projecting exposure apparatus as an example, but the present invention can naturally be applied to an apparatus having an optical system and a graphic signal processing function.

The effects to be achieved by a representative one of the invention disclosed herein will be briefly described in the following.

According to the signal processing method of the present invention, there is achieved an effect that the absolute values of symmetry of waveforms can be compared and evaluated with little erroneous recognition.

According to the method of adjusting the position detecting optical system of the present invention, moreover, there is achieved an effect that the detecting optical system can be highly precisely adjusted while discriminating the error factors such as the coma or the inclination of illumination optical axis.

According to the target pattern of the present invention, still moreover, there is achieved an effect to produce position detecting signals having excellent contrast and symmetry.

According to the exposure process of the present invention, furthermore, there is achieved an effect that a highly precise pattern transfer can be realized.

According to the exposure apparatus of the present invention, furthermore, there is achieved an effect that a highly precise pattern transfer can be realized.

## Claims

1. An exposure process in which a desired pattern on a reticle is transferred to a semiconductor wafer through a reducing projection optical system and in which said reticle and said semiconductor wafer are aligned by detecting a target pattern formed on said semiconductor wafer through a position detecting optical system, comprising: forming a portion of said semiconductor wafer with a target pattern including therein or at the background thereof the repeated steps which have such a pitch and a width as are resolved by said reducing projection optical system but not by said position detecting optical system; and aligning said semiconductor wafer with said reticle by using said target pattern.

2. An exposure process according to Claim 1 further comprising: forming said target pattern composed of lines or dots having ridge or recess flat portions of a width more than $0.5\lambda$ $(1 + \sigma)$/NA if said position detecting optical system has a detection wavelength $(\lambda)$, a numerical aperture (NA) and a partial coherency $(\sigma)$; and forming corrugated line-shaped or dot-shaped repeated steps having a pitch size less than $\lambda$ $(1 + \sigma)$/NA and a step size no less than $\lambda$/16 around said target pattern.

3. An exposure process according to Claim 1, wherein if said position detecting optical system is of a dark field type having a detection wavelength $(\lambda)$ and a numerical aperture (NA), said target pattern is composed of a plurality of dots arrayed in one direction, and wherein each of said dots is composed of corrugated line-shaped repeated steps having a pitch size less than $\lambda$ $(1 + \sigma)$/NA.

4. An exposure process according to Claim 3 wherein corrugated line-shaped repeated step portions having a pitch size less than $\lambda$ $(1 + \sigma)$/NA and a step size no less than $\lambda$/16 are formed in the background region excepting the gaps between said plurality of dots composing said target pattern.

5. A process for manufacturing a semiconductor integrated circuit device according to a reducing projection exposure exemplifying an exposure light by a substantially monochromatic coherent or partially coherent ultraviolet or far ultraviolet ray, comprising:

(a) a mask setting step of setting a mask holder in a reducing projection exposure apparatus with an optical mask which is formed with a mask pattern corresponding to a circuit pattern on at least one principal surface of a transparent mask substrate;

(b) a wafer introducing step of placing a semiconductor integrated circuit wafer having its first principal surface coated with a photoresist film, upon an XY wafer stage in said reducing projection exposure apparatus;

(c) a target position detecting step of bright-field observing the position of at least one target pattern, which is placed on said first principal surface of said wafer placed on said XY wafer stage, with respect to the exposing projection optical system of said reducing projection exposure apparatus, through an alignment optical system, which shares a portion of or is made separate of the projection optical system of said projection exposure apparatus, by a reference beam which is composed of an alignment light having a longer wavelength than said exposure light so as not to substantially sensitize said photoresist film; and

(d) an exposure step of projecting and exposing the first principal surface of said wafer, which is placed on said wafer stage, through said projection optical system by irradiating the mask, which is set in said mask holder such that a predetermined position of said wafer is relatively aligned with a desired position of said mask on the basis of positional information obtained at said target position detecting step, with said exposure light,

wherein said target pattern includes:

(i) a fine pattern region having such a fine pattern as has its contrast lowered because a period in at least one direction or a general period is far shorter than the width of said reference beam in said one direction and cannot be sufficiently resolved by said alignment optical system; and

(ii) a longer period region having such a relatively longer period or flat pattern as is substantially contiguous to the inner or outer side of said fine pattern region in said one direction and as has a sufficient contrast between its portion aid said fine pattern region because the period in at least said one direction or said general period can be sufficiently resolved by said alignment optical system.

6. A semiconductor integrated circuit device manufacturing process according to Claim 5, wherein said alignment light is substantially a monochromatic light.

7. A semiconductor integrated circuit device manufacturing process according to Claim 5, wherein said alignment optical system has a TTL (i.e., Through the Lens) construction sharing its major portion with said projection optical system.

8. A semiconductor integrated circuit device manufacturing process according to Claim 5, wherein said alignment light is substantially a continuous light having a relatively narrow band.

9. A semiconductor integrated circuit device manufacturing process according to Claim 6, wherein said alignment optical system has a TTL (i.e., Through the Lens) construction sharing its major portion with said projection optical system.

10. A semiconductor integrated circuit device manufacturing process according to Claim 8, wherein said alignment optical system has a TTL (i.e., Through the Lens) construction sharing its major portion with said projection optical system.

11. A process for manufacturing a semiconductor integrated circuit device according to a reducing projection exposure exemplifying an exposure light by a substantially monochromatic coherent or partially coherent ultraviolet or far ultraviolet ray, comprising:

(a) a mask setting step of setting a mask holder in a reducing projection exposure apparatus with an optical mask which is formed with a mask pattern corresponding to a circuit pattern on at least one principal surface of a transparent mask substrate;

(b) a wafer introducing step of placing a semiconductor integrated circuit wafer having its first principal surface coated with a photoresist film, upon an XY wafer stage in said reducing projection exposure apparatus;

(c) a target position detecting step of bright-field observing the position of at least one target pattern, which is placed on said first principal surface of said wafer placed on said XY wafer stage, with respect to the exposing projection optical system of said reducing projection exposure apparatus, through an alignment optical system, which shares a portion of or is made separate of the projection optical system of said projection exposure apparatus, by scanning a slender slit-shaped laser alignment light, which has a longer wavelength than said exposure light so as not to substantially sensitize said photoresist film, in a direction substantially perpendicular to the slit of said laser alignment light; and

(d) an exposure step of projecting and exposing the first principal surface of said wafer, which is placed on said wafer stage, through said projection optical system by irradiating the mask, which is set in said mask holder such that a predetermined position of said wafer is relatively aligned with a desired position of said mask on the basis of positional information obtained at said target position detecting step, with said exposure light,

wherein said target pattern includes:

(i) a fine pattern region having such a fine pattern as has its contrast lowered because a period in a direction along the scanning direction more than the shorter side of said slit or a general period cannot be sufficiently resolved by said alignment optical system; and
(ii) a diffraction pattern region substantially contiguous to the inner side of said fine pattern region in said scanning direction and arrayed in a direction substantially perpendicular to said scanning direction so that its predetermined diffracted light can be observed by said alignment optical system.

12. A semiconductor integrated circuit device manufacturing process according to Claim 11, wherein said alignment light is substantially a monochromatic light.

13. A semiconductor integrated circuit device manufacturing process according to Claim 11, wherein said alignment optical system has a TTL (i.e., Through the Lens) construction sharing its major portion with said projection optical system.

14. A semiconductor integrated circuit device manufacturing process according to Claim 11, wherein said alignment light is substantially a continuous light having a relatively narrow band.

15. A semiconductor integrated circuit device manufacturing process according to Claim 12, wherein said alignment optical system has a TTL (i.e., Through the Lens) construction sharing its major portion with said projection optical system.

16. A semiconductor integrated circuit device manufacturing process according to Claim 14, wherein said alignment optical system has a TTL (i.e., Through the Lens) construction sharing its major portion with said projection optical system.

## FIG. 1(a)

W1>0.5 $\lambda$(1+$\sigma$)/NA

1b

1a

P< $\lambda$(1+$\sigma$)/NA

W2<0.5 $\lambda$(1+$\sigma$)/NA

D> $\lambda$/16

IMPROVED TARGET 1

SPECIFIC EXAMPLE

WAVELENGTH $\lambda$=0.633 $\mu$m

NA=0.52

W1>0.61 $\mu$m (w=4 $\mu$m)

P<1.22 $\mu$m (P=1 $\mu$m)

W2<0.61 $\mu$m (W2=0.5 $\mu$m)

D>0.04 $\mu$m (D=0.16 $\mu$m)

$\sigma \simeq$ 0.4~0.7

## FIG. 1(b)

P< $\lambda$(1+$\sigma$)/NA

W1>0.5 $\lambda$(1+$\sigma$)/NA

2b

2a

W2<0.5 $\lambda$(1+$\sigma$)/NA

D> $\lambda$/16

IMPROVED TARGET 2

SPECIFIC EXAMPLE

WAVELENGTH $\lambda$=0.633 $\mu$m

NA=0.52

W1>0.61 $\mu$m (w=4 $\mu$m)

P<1.22 $\mu$m (P=1 $\mu$m)

W2<0.61 $\mu$m (W2=0.5 $\mu$m)

D>0.04 $\mu$m (D=0.16 $\mu$m)

$\sigma \simeq$ 0.4~0.7

## FIG. 1(c)

W>0.5 $\lambda$/NA

D> $\lambda$/16

CONVENTIONAL TARGET

SPECIFIC EXAMPLE

WAVELENGTH $\lambda$=0.633 $\mu$m

NA=0.52

W>0.61 $\mu$m (w=4 $\mu$m)

D>0.04 $\mu$m (D=0.16 $\mu$m)

# FIG. 2

WAVE DISTRIBUTION OF PUPIL
PLANE OF IMPROVED TARGET

# FIG. 5(a)

IDEAL TARGET PATTERN

# FIG. 5(b)

IDEAL WAVE DISTRIBUTION
OF PUPIL PLANE

FIG. 3(a)

GRAPHICS SIGNALS
IN NO ABERRATION

FIG. 3(b)

GRAPHICS SIGNALS
IN MISALIGNMENT
OF LIGHTING
OPTICAL AXIS

FIG. 3(c)

GRAPHICS SIGNALS
IN COMA ABERRATION

FIG. 4(a)

SYMMETRY IN
NO ABERRATION

FIG. 4(b)

SYMMETRY IN
MISALIGNMENT
OF LIGHTING
OPTICAL AXIS

FIG. 4(c)

SYMMETRY IN
COMA ABERRATION

## FIG. 6(a)

GRAPHICS SIGNALS
IN NO ABERRATION

## FIG. 6(b)

GRAPHICS SIGNALS
IN MISALIGNMENT
OF LIGHTING
OPTICAL AXIS

## FIG. 6(c)

GRAPHICS SIGNALS
IN COMA ABERRATION

# FIG. 7(a)

SYMMETRY IN
NO ABERRATION

# FIG. 7(b)

SYMMETRY IN
MISALIGNMENT
OF LIGHTING
OPTICAL AXIS

# FIG. 7(c)

SYMMETRY IN
COMA ABERRATION

## FIG. 8

```
( START )
     │
     ▼
┌─────────────────────────────────────────────┐
│ FETCH GRAPHICS SIGNALS OF TARGET PATTERN FOR │
│ CHECKING MISALIGNMENT OF LIGHTING OPTICAL AXIS│
└─────────────────────────────────────────────┘
     │
     ▼
┌─────────────────────────────────────────────┐
│ DETERMINE S(j) BY PROCESSING OF NORMALIZED SYMMETRY │
└─────────────────────────────────────────────┘
     │
     ▼                                     OK
 < S(j) VALUE EVALUATED ? > ──────────────►
     │ NO
     ▼
┌─────────────────────────────────────────────┐
│        ADJUST MISAILIGNMENT OF OPTICAL       │
│      AXIS OF POSITIONING OPTICAL SYSTEM      │
└─────────────────────────────────────────────┘

┌─────────────────────────────────────────────┐
│         FETCH GRAPHICS SIGNALS OF TARGET     │
│     PATTERN FOR CHECKING COMA ABERRATIOR     │
└─────────────────────────────────────────────┘
     │
     ▼
┌─────────────────────────────────────────────┐
│ DETERMINE S(j) BY PROCESSING OF NORMALIZED SYMMETRY │
└─────────────────────────────────────────────┘
     │
     ▼                                     OK
 < S(j) VALUE EVALUATED ? > ──────────────►
     │ NO
     ▼
┌─────────────────────────────────────────────┐
│ ADJUST COMA ABERRATION OF POSITIONING OPTICAL SYSTEM │
└─────────────────────────────────────────────┘

┌─────────────────────────────────────────────┐
│           FORM TARGET PATTERN ON WAFER        │
└─────────────────────────────────────────────┘
     │
     ▼
┌─────────────────────────────────────────────┐
│ DETECT TARGET PATTERN BY POSITIONING OPTICAL │
│  SYSTEM TO EXECUTE ALIGNMENT AND EXPOSURE    │
└─────────────────────────────────────────────┘
     │
     ▼
  ( END )
```

FIG. 9(a)

GRAPHICS SIGNALS
IN NO ABERRATION

FIG. 9(b)

GRAPHICS SIGNALS
IN MISALIGNMENT
OF LIGHTING
OPTICAL AXIS

FIG. 9(c)

GRAPHICS SIGNALS
IN COMA ABERRATION

FIG. 10(a)

SYMMETRY IN
NO ABERRATION

FIG. 10(b)

SYMMETRY IN
MISALIGNMENT
OF LIGHTING
OPTICAL AXIS

FIG. 10(c)

SYMMETRY IN
COMA ABERRATION

*FIG. 11(a)*

GRAPHICS SIGNALS
IN NO ABERRATION

*FIG. 11(b)*

GRAPHICS SIGNALS
IN MISALIGNMENT
OF LIGHTING
OPTICAL AXIS

*FIG. 11(c)*

GRAPHICS SIGNALS
IN COMA ABERRATION

## FIG. 12(a)

SYMMETRY IN
NO ABERRATION

## FIG. 12(b)

SYMMETRY IN
MISALIGNMENT
OF LIGHTING
OPTICAL AXIS

## FIG. 12(c)

SYMMETRY IN
COMA ABERRATION

FIG. 13(a)

W1  W2

P

W3

101

101a

101a

101b

FIG. 13(b)

101a

L1

L

W1

A

101b

## FIG. 14 (a)

## FIG. 14 (b)

FIG. 15(a)

FIG. 15(b)

# FIG. 16 (a)

# FIG. 16 (b)

## FIG. 17(a)

## FIG. 17(b)

# FIG. 18

LIGHT SHIELDING PLATE

3rd-ORDER DIFFACTED LIGHT
2nd-ORDER DIFFACTED LIGHT
1st-ORDER DIFFACTED LIGHT
0th-ORDER DIFFACTED LIGHT

DETECTION RANGE

0th-ORDER DIFFRACTED LIGHT

LASER BEAM

DOT PORTION (LINE PORTION)

DETECTED VOLTAGE

TARYET SIGNAL

GRAIN

LASER BEAM (61a)

101b(103b)

LASER BEAM

LASER BEAM

LASER BEAM POSITION

EP 0 701 174 A1

# FIG. 19

SCATTERED LIGHT

LIGHT-SHIELDING PLATE

DETECTION RANGE

0th-ORDER DIFFRACTED LIGHT

LASER BEAM

GRAIN

DOT PORTION

LASER BEAM

DETECTED VOLTAGE

TARGET SIGNAL

NOISE

LASER BEAM POSITION

# FIG. 20

SIGNAL
PROCESSING
UNIT

EP 0 701 174 A1

# FIG. 21

EP 0 701 174 A1

EP 0 701 174 A1

# FIG. 22

EXPOSING
ILLUMINATION

DETECTING
OPTICAL
SYSTEM

RETICLE

TV CAMERA

DETECTING
ILLUMINATION

PROJECTION LENS

WAFER

XY STAGE

PROJECTION/
EXPOSURE
APPARATUS

# FIG. 23(a)

RESIST PATTERN

TEST PATTERN

# FIG. 23(b)

LEFTHAND
HEIGHT

RIGHTHAND
HEIGHT

SIGNAL OF
TEST PATTERN

ADJUSTING METHOD OF PRIOR ART

# FIG. 24

RESIST
DEPOSITED FILM ON TARGET
} TARGET STEP
SUBSTRATE

TARGET PATTERN OF PRIOR ART

# FIG. 25

LIGHT-SHIELDING PLATE
(SPATIAL FILTER)
(CONJUGATE PLATE
OF ENTRANCE PUPIL)

DETECTOR

ENTRANCE PUPIL

CYLINDRICAL
LENS

LASER LIGHT SOURCE

STAGE
SCANNING

POSITION DETECTING OPTICAL
SYSTEM OF DARK FIELD SYSTEM

*FIG. 26*

LASER BEAM

EDGE E2    EDGE E1

SCANNING
DIRECTION

$8\,\mu m$    $4\,\mu m$

$4\,\mu m$

*FIG. 27*

*FIG. 28(a)*

DIFFRACTED IMAGE
AT EDGE E2 SIDE

*FIG. 28(b)*

DIFFRACTED IMAGE
AT EDGE E1 SIDE

DETECTING NA
(NUMERICAL APERTURE)

DENSE

0TH-ORDER
LIGHT

DENSE

±1ST-ORDER
LIGHT

±3RD-ORDER
LIGHT

## FIG. 29

PITCH<$\lambda$/NA

b

a (103b)

## FIG. 30

DETECTING NA
(NUMERICAL APERTURE)

a

b

c

0TH-ORDER
LIGHT

±1ST-ORDER
LIGHT

±3RD-ORDER
LIGHT

European Patent Office

**EUROPEAN SEARCH REPORT**

Application Number

EP 95 30 2844

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US-A-5 172 189 (MITOME NORIYUKI) 15 December 1992<br>* column 3, line 48 - column 8, line 36 *<br>* figures 1-3 *<br>--- | 1,5,11 | G03F9/00 |
| A | US-A-4 632 557 (THOMPSON THOMAS K) 30 December 1986<br>* column 2, line 5 - column 4, line 17 *<br>* figures *<br>--- | 1,5,11 | |
| A | US-A-4 374 915 (AHLQUIST C NORMAN ET AL) 22 February 1983<br>* column 3, line 47 - column 4, line 19 *<br>* figures 7,8 *<br>------ | 1,5,11 | |
| | | | TECHNICAL FIELDS SEARCHED (Int.Cl.6) |
| | | | G03F |

The present search report has been drawn up for all claims

| Place of search | Date of completion of the search | Examiner |
|---|---|---|
| THE HAGUE | 12 December 1995 | Heryet, C |

EPO FORM 1503 03.82 (P04C01)